# EUROPEAN PATENT APPLICATION

(11) **EP 4 637 298 A1**
(43) Date of publication of application: **22.10.2025**
(21) Application number: 25170773.3
(22) Date of filing: 15.04.2025
(51) Int. Cl.: H10D 86/40, G09G 3/00, H10K 59/121, H10K 59/126, H10K 59/131

(54) **DISPLAY DEVICE AND ELECTRONIC DEVICE INCLUDING THE SAME**

(30) Priority: 18.04.2024 KR 20240052100
(71) Applicant: Samsung Display Co., Ltd., Yongin-si, Gyeonggi-do 17113 (KR)
(72) Inventor: KIM, BYUNGSUN, 17113 Yongin-si (KR); JO, EUNBYUL, 17113 Yongin-si (KR)
(74) Representative: Taor, Simon Edward William

(57) **Abstract**

A display device includes a substrate including a display area and a peripheral area surrounding a portion of the display area, a gate driver disposed in the display area on the substrate, including a driver transistor, and that generates a first gate signal, first pixel members disposed on the gate driver, each including a first pixel transistor, and overlapping the gate driver in a plan view, a connection part disposed in the peripheral area adjacent to the gate driver on the substrate and including a first conductive pattern and a second conductive pattern disposed on the first conductive pattern and connected to the first conductive pattern through a contact hole, a connection line extending from the first conductive pattern and connected to the gate driver, and a gate signal line disposed on the connection line, extending from the second conductive pattern, and connected to each of the first pixel members.

## Description

### BACKGROUND

### 1. Technical Field

Embodiments provide generally to a display device. Embodiments relate to a display device that provides visual information.

### 2. Description of the Related Art

As information technology develops, the importance of display devices, which are communication media between users and information, is being highlighted. Accordingly, the use of display devices such as a liquid crystal display device, an organic light emitting display device, a plasma display device, and the like is increasing.

In general, a display device may include a display area where an image is displayed and a peripheral area where a gate driver, a data driver, and the like are disposed and surrounding the display area. The larger the area occupied by the gate driver in the peripheral area, the larger the dead space of the display device may be.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Embodiments provide a display device with a reduced dead space.

A display device according to embodiments may include a substrate including a display area and a peripheral area surrounding at least a portion of the display area; a gate driver disposed in the display area on the substrate, the gate driver including a driver transistor, and that generates a first gate signal; a plurality of first pixel members disposed on the gate driver, each of the plurality of first pixel members including a first pixel transistor, and at least partially overlapping the gate driver in a plan view, a connection part disposed in the peripheral area adjacent to the gate driver on the substrate, the connection part including a first conductive pattern and a second conductive pattern disposed on the first conductive pattern and electrically connected to the first conductive pattern through a contact hole, a connection line extending from the first conductive pattern and electrically connected to the gate driver; and a gate signal line disposed on the connection line, extending from the second conductive pattern, the gate signal line electrically connected to each of the plurality of first pixel members.

In an embodiment, the gate driver may overlap a left edge of the display area or a right edge of the display area.

In an embodiment, the display device may further include a shielding pattern disposed between the gate driver and the plurality of first pixel members, and at least partially overlapping the driver transistor in a plan view.

In an embodiment, the display device may further include a plurality of second pixel members disposed in the display area on the gate driver, each of the plurality of second pixel members including a second pixel transistor, and not overlapping the gate driver in a plan view.

In an embodiment, the first pixel transistor may include a first pixel active layer disposed on the gate driver and a pixel gate electrode disposed on the first pixel active layer and partially overlapping a channel region of the first pixel active layer in a plan view. Each of the plurality of first pixel members may further include a first electrode disposed on the first pixel active layer and electrically connected to a first doped region of the first pixel active layer through a first contact hole and a second electrode disposed on the first pixel active layer and electrically connected to a second doped region of the first pixel active layer through a second contact hole.

In an embodiment, a size of the contact hole may be different from a size of each of the first contact hole and the second contact hole.

In an embodiment, a size of the contact hole may be larger than a size of each of the first contact hole and the second contact hole.

In an embodiment, the first pixel active layer may include a metal oxide semiconductor.

In an embodiment, the driver transistor may include a driver active layer disposed on the substrate and a driver gate electrode disposed on the driver active layer and overlapping a channel region of the driver active layer.

In an embodiment, the driver active layer may include a silicon semiconductor.

In an embodiment, the gate driver may further include a lower metal layer disposed between the substrate and the driver active layer, and electrically connected to the driver active layer and a connection pattern and the driver gate electrode disposed on a same layer and electrically connected to the lower metal layer.

In an embodiment, the first conductive pattern and the driver gate electrode may be disposed in a same layer and the second conductive pattern and the first electrode and the second electrode may be disposed in a same layer.

In an embodiment, the first conductive pattern and the lower metal layer may be disposed in a same layer and the second conductive pattern and the first electrode and the second electrode may be disposed in a same layer.

In an embodiment, the first conductive pattern and the driver gate electrode may be disposed in a same layer and the second conductive pattern and the pixel gate electrode may be disposed in a same layer.

In an embodiment, the first conductive pattern and the lower metal layer may be disposed in a same layer and the second conductive pattern and the pixel gate electrode may be disposed in a same layer.

In an embodiment, the first conductive pattern may include a first-first conductive pattern and the lower metal layer disposed in a same layer and a first-second conductive pattern and the driver gate electrode disposed in a same layer. The connection line may include a first-first connection line extending from the first-first conductive pattern and a first-second connection line extending from the first-second conductive pattern. The second conductive pattern and the first electrode and the second electrode may be disposed in a same layer.

In an embodiment, the display device may further include at least one dummy gate driver disposed in the display area on the substrate, including a dummy transistor, and spaced apart from the gate driver and a plurality of second pixel members disposed in the display area on the dummy gate driver and each of the plurality of second pixel members including a second pixel transistor.

In an embodiment, the display device may further include at least one additional gate driver disposed in the display area on the substrate and that generates a second gate signal and a plurality of second pixel members disposed in the display area on the additional gate driver and each of plurality of second pixel members including a second pixel transistor. The additional gate driver may be electrically connected to at least one of the plurality of first pixel members and the plurality of second pixel members.

A display device according to embodiments may include a substrate including a display area and a peripheral area surrounding at least a portion of the display area; a gate driver disposed in the display area on the substrate, that generates a first gate signal, the gate driver including a plurality of gate stages each of the plurality of gate stages including a driver transistor; a plurality of first pixel members disposed on the gate driver, each of the plurality of first pixel members including a first pixel transistor, and at least partially overlapping the plurality of gate stages in a plan view, a connection part disposed in the peripheral area adjacent to the gate driver on the substrate, the connection part including a plurality of sub-connection parts each including a first conductive pattern and a second conductive pattern disposed on the first conductive pattern and electrically connected to the first conductive pattern through a contact hole; a connection line extending from the first conductive pattern of one of the plurality of sub-connection parts and electrically connected to the each of gate stages, and a gate signal line disposed on the connection line, extending from the second conductive pattern of one of the plurality of sub-connection parts, and electrically connected to each of the first pixel members.

In an embodiment, the display device may further include a shielding pattern disposed between the gate driver and the plurality of first pixel members, and at least partially overlapping the driver transistor in a plan view.

In an embodiment, the display device may further include a plurality of second pixel members disposed in the display area on the gate driver, each of the plurality of second pixel members including a second pixel transistor, and not overlapping the gate driver in a plan view.

In an embodiment, the first pixel transistor may include a first pixel active layer disposed on the gate driver and a pixel gate electrode disposed on the first pixel active layer and partially overlapping a channel region of the first pixel active layer in a plan view. Each of the plurality of first pixel members may further include a first electrode disposed on the first pixel active layer and electrically connected to a first doped region of the first pixel active layer through a first contact hole and a second electrode disposed on the first pixel active layer and electrically connected to a second doped region of the first pixel active layer through a second contact hole.

In an embodiment, a size of the contact hole may be larger than a size of each of the first contact hole and the second contact hole.

In an embodiment, the driver transistor may include a driver active layer disposed on the substrate and a driver gate electrode disposed on the driver active layer and overlapping a channel region of the driver active layer.

In an embodiment, the gate driver may further include a lower metal layer disposed between the substrate and the driver active layer, and electrically connected to the driver active layer and a connection pattern and the driver gate electrode disposed on a same layer and electrically connected to the lower metal layer.

In an embodiment, the first conductive pattern and one of the lower metal layer and the driver gate electrode may be disposed in a same layer and the second conductive pattern and one of the first electrode or the pixel gate electrode may be disposed in a same layer.

In an embodiment, the display device may further include at least one dummy gate driver disposed in the display area on the substrate, including a dummy transistor, and spaced apart from the gate driver and a plurality of second pixel members disposed in the display area on the dummy gate driver and each of the plurality of second pixel members including a second pixel transistor.

In an embodiment, the display device may further include at least one additional gate driver disposed in the display area on the substrate and that generates a second gate signal and a plurality of second pixel members disposed in the display area on the additional gate driver and each of the plurality of second pixel members including a second pixel transistor. The additional gate driver may be electrically connected to at least one of the plurality of first pixel members and the plurality of second pixel members.

An electronic device according to embodiments may include a display device and a processor which controls the display device. The display device includes: a substrate including a display area and a peripheral area surrounding at least a portion of the display area, a gate driver disposed in the display area on the substrate, the gate driver including a driver transistor, and that generates a first gate signal, a plurality of first pixel members disposed on the gate driver, each of the plurality of first pixel members including a first pixel transistor, and at least partially overlapping the gate driver in a plan view, a connection part disposed in the peripheral area adjacent to the gate driver on the substrate, the connection part including a first conductive pattern and a second conductive pattern disposed on the first conductive pattern and electrically connected to the first conductive pattern through a contact hole, a connection line extending from the first conductive pattern and electrically connected to the gate driver, and a gate signal line disposed on the connection line, extending from the second conductive pattern, the gate signal line electrically connected to each of the plurality of first pixel members.

According to an aspect, there is provided a display device as set out in claim 1. Additional features are set out in claims 2 to 11. According to an aspect, there is provided a display device as set out in claim 12. Additional features are set out in claims 13 to 15. According to an aspect, there is provided an electronic device as set out in claim 16.

In a display device according to embodiments, a gate driver that generates a gate signal may be disposed in the display area, and a pixel structure that at least partially overlaps the gate driver in a plan view may be disposed in the display area on the gate driver. The gate driver may be connected to the pixel structure through a connection part disposed in a peripheral area.
Accordingly, a dead space of the display device may be reduced.

### BRIEF DESCRIPTION OF THE DRAWINGS

Illustrative, non-limiting embodiments will be more clearly understood from the following detailed description in conjunction with the accompanying drawings in which:
FIG. 1 is a schematic plan view showing a display device according to an embodiment.
FIG. 2 is an enlarged schematic plan view of area A of FIG. 1.
FIG. 3 is a schematic cross-sectional view taken along line I-I' of FIG. 1.
FIG. 4 is a schematic cross-sectional view showing an embodiment of a cross section taken along lines II-II' and III-III' of FIG. 2.
FIGS. 5, 6, 7, 8, 9, 10, and 11 are schematic cross-sectional views for explaining a method for manufacturing the display device of FIG. 4.
FIG. 12 is a schematic cross-sectional view showing an embodiment of a cross section taken along lines II-II' and III-III' of FIG. 2.
FIG. 13 is a schematic cross-sectional view showing an embodiment of a cross section taken along lines II-II' and III-III' of FIG. 2.
FIG. 14 is a schematic cross-sectional view showing an embodiment of a cross section taken along lines II-II' and III-III' of FIG. 2.
FIG. 15 is a schematic cross-sectional view showing an embodiment of a cross section taken along lines II-II' and III-III' of FIG. 2.
FIG. 16 is a schematic plan view showing a display device according to an embodiment.
FIG. 17 is a schematic plan view showing a portion of a display device according to an embodiment.
FIG. 18 is a schematic cross-sectional view taken along line IV-IV' of FIG. 17.
FIG. 19 is a schematic plan view showing a portion of a display device according to an embodiment.
FIG. 20 is a schematic block diagram illustrating an electronic device according to an embodiment.

### DETAILED DESCRIPTION OF THE EMBODIMENTS

Hereinafter, a display device according to embodiments will be explained in detail with reference to the accompanying drawings. The same reference numerals are used for the same components in the drawings, and redundant descriptions of the same components may be omitted.

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, sizes, thicknesses, ratios, and dimensions of the elements may be exaggerated for ease of description and for clarity. Like numbers refer to like elements throughout.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the disclosure.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

When an element is described as 'not overlapping' or 'to not overlap' another element, this may include that the elements are spaced apart from each other, offset from each other, or set aside from each other or any other suitable term as would be appreciated and understood by those of ordinary skill in the art.

The terms "comprises," "comprising," "includes," and/or "including," "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be understood that when an element (or a region, a layer, a portion, or the like) is referred to as "being on", "connected to" or "coupled to" another element in the specification, it can be directly disposed on, connected or coupled to another element mentioned above, or intervening elements may be disposed therebetween.

It will be understood that the terms "connected to" or "coupled to" may include a physical or electrical connection or coupling.

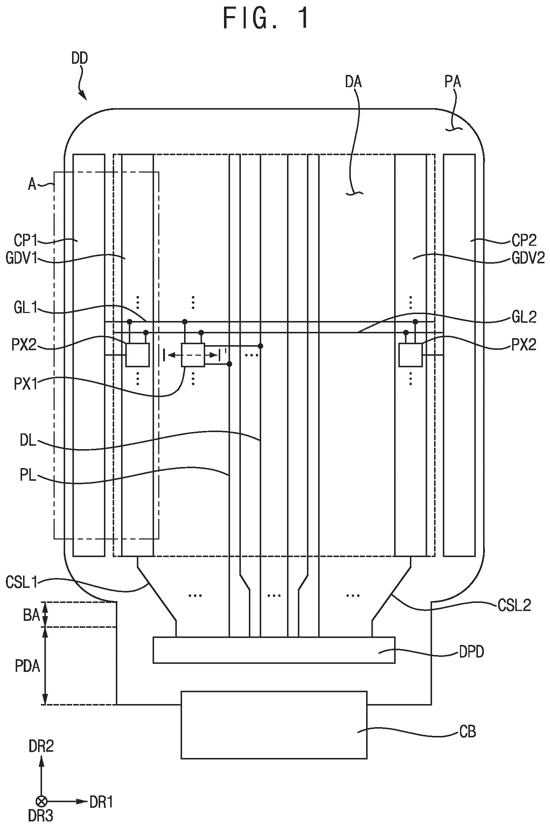

FIG. 1 is a schematic plan view showing a display device according to an embodiment.

In this specification, a plane may be defined as a first direction DR1 and a second direction DR2 intersecting the first direction DR1. For example, the first direction DR1 may be perpendicular to the second direction DR2. A third direction DR3 may be perpendicular to the plane.

Referring to FIG. 1, a display device DD according to an embodiment may include pixel structures (or pixel members) PX1 and PX2, a display panel driver DPD, a circuit board CB, a first gate driver GDV1, a second gate driver GDV2, a first connection part CP1, and a second connection part CP2.

The display device DD may be divided into a display area DA and a peripheral area PA. The display area DA may be an area that can display an image by generating light or adjusting the transmittance of light provided from an external light source. The peripheral area PA may be an area that does not display images. The peripheral area PA may surround at least a portion of the display area DA. For example, the peripheral area PA may entirely surround the display area DA.

The peripheral area PA may include a bending area BA and a pad area PDA. The bending area BA may be located (or disposed) between the display area DA and the pad area PDA in a plan view. The bending area BA may be bent based on a bending axis extending in the first direction DR1. The pad area PA may have a shape extending along one side or a side of the display device DD. For example, the pad area PA may have a shape extending along the first direction DR1.

The pixel structures PX1 and PX2 may be arranged (or disposed) in the display area DA. Each of the pixel structures PX1 and PX2 may include a driving element (for example, a thin film transistor) that generates a driving current, and a light emitting element electrically that is connected to the driving element and generates light based on the driving current. Accordingly, each of the pixel structures PX1 and PX2 may generate light according to the driving current. The pixel structures PX1 and PX2 may be entirely arranged in the display area DA in a matrix form along the first direction DR1 and the second direction DR2.

The pixel structures PX1 and PX2 may include first pixel structures PX1 and second pixel structures PX2. The second pixel structures PX2 may be arranged at the left and right edges of the display area DA. The first pixel structures PX1 may be arranged in the remaining area of the display area DA excluding the area where the second pixel structures PX2 are arranged.

Drivers for driving the pixel structures PX1 and PX2 may be disposed in the peripheral area PA. For example, the display panel driver DPD may be disposed in the peripheral area PA.

A data line DL, a first gate signal line GL1, a second gate signal line GL2, and a driving voltage line PL connected to the pixel structures PX1 and PX2 may be disposed in the display area DA. Although not shown in detail in FIG. 1, the data line DL and the driving voltage line PL may also be connected to the second pixel structure PX2. A first control signal line CSL1 connected to the first gate driver GDV1 and a second control signal line CSL2 connected to the second gate driver GDV2 may be disposed in the peripheral area PA.

The first gate signal line GL1 may be electrically connected to the first gate driver GDV1 and extend in the first direction DR1. The first gate signal line GL1 may receive a first gate signal from the first gate driver GDV1 and provide the first gate signal to the pixel structures PX1 and PX2.

The second gate signal line GL2 may be electrically connected to the second gate driver GDV2 and may extend in the first direction DR1. The second gate signal line may receive a second gate signal from the second gate driver GDV2 and provide the second gate signal to the pixel structures PX1 and PX2.

For example, the first gate signal may be a different type of electrical signal than the second gate signal. However, embodiments are not limited thereto. By way of example, the first gate signal may be the same type of electrical signal as the second gate signal.

The data line DL may be electrically connected to the display panel driver DPD and may extend along the second direction DR2. The data line DL may receive a data voltage from the display panel driver DPD and provide the data voltage to the data line DL. The data line DL may provide the data voltage to the pixel structures PX1 and PX2.

The driving voltage line PL may be electrically connected to the display panel driver DPD and extend along the second direction DR2. The driving voltage line PL may receive a driving voltage from the display panel driver DPD and provide the driving voltage to the pixel structures PX1 and PX2. For example, the driving voltage may be a high power voltage for driving the pixel structures PX1 and PX2.

The first control signal line CSL1 may be electrically connected to the display panel driver DPD. The first control signal line CSL1 may receive a first control signal from the display panel driver DPD and provide the first control signal to the first gate driver GDV1.

The second control signal line CSL2 may be electrically connected to the display panel driver DPD. The second control signal line CSL2 may receive a second control signal from the display panel driver DPD and provide the second control signal to the second gate driver GDV2.

The display panel driver DPD may be disposed in the pad area PDA. The display panel driver DPD may be formed as an integrated circuit (IC). For example, in case that a substrate of the display device DD may include glass, the display panel driver DPD may have a chip on glass (COG) structure disposed directly on the substrate. By way of example, in case that the substrate may include plastic, the display panel driver DPD may be a chip on plastic (COP) structure disposed directly on the substrate. However, embodiments are not limited thereto.

The display panel driver DPD may generate various signals and/or voltages. For example, the display panel driver DPD may generate the first control signal, the second control signal, the driving voltage, the data voltage, and the like within the scope of the disclosure.

The first gate driver GDV1 may include at least one driver transistor. In an embodiment, the first gate driver GDV1 may be disposed in the display area DA. For example, the first gate driver GDV1 may entirely overlap the display area DA and may not overlap the peripheral area PA. In this case, the first gate driver GDV1 may at least partially overlap the second pixel structures PX2 in the plan view. For example, the first gate driver GDV1 may overlap the left edge of the display area DA.

The first gate driver GDV1 may receive the first control signal from the display panel driver DPD and generate the first gate signal based on the first control signal.

The second gate driver GDV2 may include at least one driver transistor. In an embodiment, the second gate driver GDV2 may be disposed in the display area DA. For example, the second gate driver GDV2 may entirely overlap the display area DA and may not overlap the peripheral area PA. In this case, the second gate driver GDV2 may at least partially overlap the second pixel structures PX2 in the plan view. For example, the second gate driver GDV2 may overlap the right edge of the display area DA.

The second gate driver GDV2 may receive the second control signal from the display panel driver DPD and generate the second gate signal based on the second control signal.

The first gate driver GDV1 and the second gate driver GDV2 may not overlap the first pixel structures PX1 in the plan view.

The first connection part CP1 and the second connection part CP2 may be disposed in the peripheral area PA. For example, the first connection part CP1 may be disposed in the peripheral area PA adjacent to the first gate driver GDV1, and the second connection part CP2 may be disposed in the peripheral area PA adjacent to the second gate driver GDV2.

In an embodiment, the first gate driver GDV1 and the first connection part CP1 may be connected through a connection line, and the first connection part CP1 and the pixel structures PX1 and PX2 may be connected through the first gate signal line GL1. Likewise, the second gate driver GDV2 and the second connection part CP2 may be connected through a connection line, and the second connection part CP2 and the pixel structures PX1 and PX2 may be connected through the second gate signal line GL2. Accordingly, the first gate driver GDV1 may be electrically connected to the pixel structures PX1 and PX2 through the first connection part CP1, and provide the first gate signal to the pixel structures PX1 and PX2 through the first connection part CP1. The second gate driver GDV2 may be electrically connected to the pixel structures PX1 and PX2 through the second connection part CP2, and provide the second gate signal to the pixel structures PX1 and PX2 through the second connection part CP2.

The circuit board CB may be disposed in the pad area PDA. For example, the circuit board CB may partially overlap the pad area PDA. For example, a first portion of the circuit board CB may overlap the pad area PDA, and a second portion of the circuit board CB excluding the first portion may not overlap the pad area PDA. The circuit board CB may be bonded to the substrate through an adhesive layer (for example, an anisotropic conductive film). The circuit board CB may provide voltage, control signals, and the like to the display panel driver DPD.

For example, the circuit board CB may include a printed circuit board (PCB), a flexible printed circuit board (FPCB), or a flexible flat cable (FFC). However, embodiments are not limited thereto.

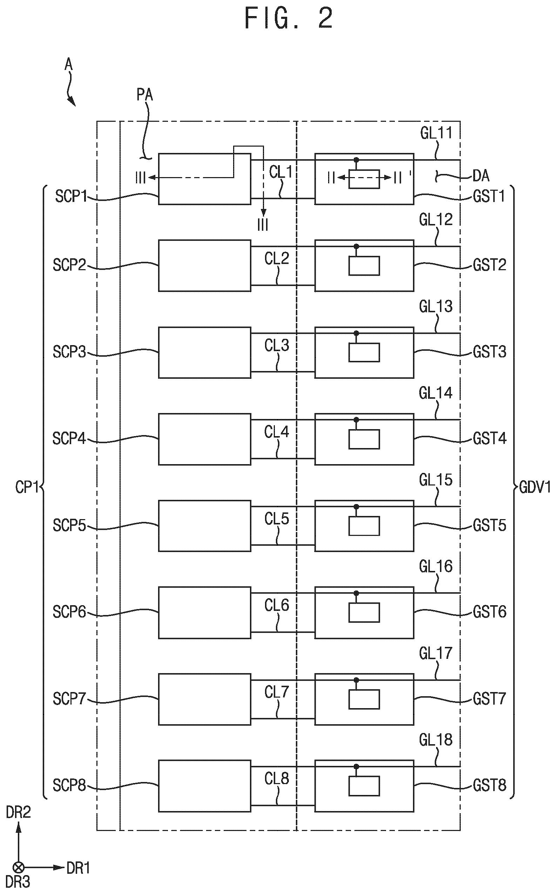

FIG. 2 is an enlarged schematic plan view of area A of FIG. 1. For example, FIG. 2 is a schematic plan view showing the respective components of the first gate driver GDV1 and the first connection part CP1 of FIG. 1.

Referring to FIG. 2, the first gate driver GDV1 may include gate stages. For example, the gate stages may include first, second, third, fourth, fifth, sixth, seventh, and eighth gate stages GST1, GST2, GST3, GST4, GST5, GST6, GST7, and GST8. The first, second, third, fourth, fifth, sixth, seventh, and eighth gate stages GST1, GST2, GST3, GST4, GST5, GST6, GST7, and GST8 may be disposed to be spaced apart from each other in the second direction DR2. However, the number of gate stages shown in FIG. 2 is for convenience of explanation, and the number of gate stages is not limited thereto.

The first, second, third, fourth, fifth, sixth, seventh, and eighth gate stages GST1, GST2, GST3, GST4, GST5, GST6, GST7, and GST8 may receive various control signals and voltages. The first, second, third, fourth, fifth, sixth, seventh, and eighth gate stages GST1, GST2, GST3, GST4, GST5, GST6, GST7, and GST8 may generate first gate signals in response to various control signals and voltages. The first gate signals may be applied to connection lines (for example, first, second, third, fourth, fifth, sixth, seventh, and eighth connection lines CL1, CL2, CL3, CL4, CL5, CL6, CL7, and CL8).

The first connection part CP1 may include sub-connection parts. For example, the sub-connectors may include first, second, third, fourth, fifth, sixth, seventh, and eighth sub-connection parts SCP1, SCP2, SCP3, SCP4, SCP5, SCP6, SCP7, and SCP8. The first, second, third, fourth, fifth, sixth, seventh, and eighth sub-connection parts SCP1, SCP2, SCP3, SCP4, SCP5, SCP6, SCP7, and SCP8 may be disposed to be spaced apart from each other in the second direction DR2. However, the number of sub-connection parts shown in FIG. 2 is for convenience of explanation, and the number of sub-connection parts is not limited thereto.

The first sub-connection part SCP1 and the first gate stage GST1 may be connected through the first connection line CL1, and the first sub-connection part SCP1 and the second pixel structure PX2 located in a first row may be connected through a first-first gate signal line GL11. The first-first gate signal line GL11 may also be connected to the first pixel structure PX1 of FIG. 1 located in the first row. Accordingly, the first gate stage GST1 may be electrically connected to the first and second pixel structures PX1 and PX2 located in the first row through the first sub-connection part SCP1. In this case, the first gate signal may be provided to the first and second pixel structures PX1 and PX2 located in the first row through the first connection line CL1, the first sub-connection part SCP1, and the first-first gate signal line GL11.

The second sub-connection part SCP2 and the second gate stage GST2 may be connected through the second connection line CL2, and the second sub-connection part SCP2 and the second pixel structure PX2 located in a second row may be connected through a first-second gate signal line GL12. The first-second gate signal line GL12 may also be connected to the first pixel structure PX1 of FIG. 1 located in the second row. Accordingly, the second gate stage GST2 may be electrically connected to the first and second pixel structures PX1 and PX2 located in the second row through the second sub-connection part SCP2. In this case, the first gate signal may be provided to the first and second pixel structures PX1 and PX2 located in the second row through the second connection line CL2, the second sub-connection part SCP2, and the first-second gate signal line GL12.

The third sub-connection part SCP3 and the third gate stage GST3 may be connected through the third connection line CL3, and the third sub-connection part SCP3 and the second pixel structure PX2 located in a third row may be connected through a first-third gate signal line GL13. The first-third gate signal line GL13 may also be connected to the first pixel structure PX1 of FIG. 1 located in the third row. Accordingly, the third gate stage GST3 may be electrically connected to the first and second pixel structures PX1 and PX2 located in the third row through the third sub-connection part SCP3. In this case, the first gate signal may be provided to the first and second pixel structures PX1 and PX2 located in the third row through the third connection line CL3, the third sub-connection part SCP3, and the first-third gate signal line GL13.

The fourth sub-connection part SCP4 and the fourth gate stage GST4 may be connected through the fourth connection line CL4, and the fourth sub-connection part SCP4 and the second pixel structure PX2 located in a fourth row may be connected through a first-fourth gate signal line GL14. The first-fourth gate signal line GL14 may also be connected to the first pixel structure PX1 of FIG. 1 located in the fourth row. Accordingly, the fourth gate stage GST4 may be electrically connected to the first and second pixel structures PX1 and PX2 located in the fourth row through the fourth sub-connection part SCP4. In this case, the first gate signal may be provided to the first and second pixel structures PX1 and PX2 located in the fourth row through the fourth connection line CL4, the fourth sub-connection part SCP4, and the first-fourth gate signal line GL14.

The fifth sub-connection part SCP5 and the fifth gate stage GSTS may be connected through the fifth connection line CL5, and the fifth sub-connection part SCP5 and the second pixel structure PX2 located in a fifth row may be connected through a first-fifth gate signal line GL15. The first-fifth gate signal line GL15 may also be connected to the first pixel structure PX1 of FIG. 1 located in the fifth row. Accordingly, the fifth gate stage GSTS may be electrically connected to the first and second pixel structures PX1 and PX2 located in the fifth row through the fifth sub-connection part SCP5. In this case, the first gate signal may be provided to the first and second pixel structures PX1 and PX2 located in the fifth row through the fifth connection line CL5, the fifth sub-connection part SCP5, and the first-fifth gate signal line GL15.

The sixth sub-connection part SCP6 and the sixth gate stage GST6 may be connected through the sixth connection line CL6, and the sixth sub-connection part SCP6 and the second pixel structure PX2 located in a sixth row may be connected through a first-sixth gate signal line GL16. The first-sixth gate signal line GL16 may also be connected to the first pixel structure PX1 of FIG. 1 located in the sixth row. Accordingly, the sixth gate stage GST6 may be electrically connected to the first and second pixel structures PX1 and PX2 located in the sixth row through the sixth sub-connection part SCP6. In this case, the first gate signal may be provided to the first and second pixel structures PX1 and PX2 located in the sixth row through the sixth connection line CL6, the sixth sub-connection part SCP6, and the first-sixth gate signal line GL16.

The seventh sub-connection part SCP7 and the seventh gate stage GST7 may be connected through the seventh connection line CL7, and the seventh sub-connection part SCP7 and the second pixel structure PX2 located in a seventh row may be connected through a first-seventh gate signal line GL17. The first-seventh gate signal line GL17 may also be connected to the first pixel structure PX1 of FIG. 1 located in the seventh row. Accordingly, the seventh gate stage GST7 may be electrically connected to the first and second pixel structures PX1 and PX2 located in the seventh row through the seventh sub-connection part SCP7. In this case, the first gate signal may be provided to the first and second pixel structures PX1 and PX2 located in the seventh row through the seventh connection line CL7, the seventh sub-connection part SCP7, and the first-seventh gate signal line GL17.

The seventh sub-connection part SCP7 and the seventh gate stage GST7 may be connected through the seventh connection line CL7, and the seventh sub-connection part SCP7 and the second pixel structure PX2 located in a seventh row may be connected through a first-seventh gate signal line GL17. The first-seventh gate signal line GL17 may also be connected to the first pixel structure PX1 of FIG. 1 located in the seventh row. Accordingly, the seventh gate stage GST7 may be electrically connected to the first and second pixel structures PX1 and PX2 located in the seventh row through the seventh sub-connection part SCP7. In this case, the first gate signal may be provided to the first and second pixel structures PX1 and PX2 located in the seventh row through the seventh connection line CL7, the seventh sub-connection part SCP7, and the first-seventh gate signal line GL17.

The eighth sub-connection part SCP8 and the eighth gate stage GST8 may be connected through the eighth connection line CL8, and the eighth sub-connection part SCP8 and the second pixel structure PX2 located in an eighth row may be connected through a first-eighth gate signal line GL18. The first-eighth gate signal line GL18 may also be connected to the first pixel structure PX1 of FIG. 1 located in the eighth row. Accordingly, the eighth gate stage GST8 may be electrically connected to the first and second pixel structures PX1 and PX2 located in the eighth row through the eighth sub-connection part SCP8. In this case, the first gate signal may be provided to the first and second pixel structures PX1 and PX2 located in the eighth row through the eighth connection line CL8, the eighth sub-connection part SCP8, and the first-eighth gate signal line GL18.

Each of the first-first, first-second, first-third, first-fourth, first-fifth, first-sixth, first-seventh, and first-eighth gate signal lines GL11, GL12, GL13, GL14, GL15, GL16, GL17, and GL18 of FIG. 2 may correspond to the first gate signal line GL1 of FIG. 1.

Components of the first gate driver GDV1 of FIG. 2 may be substantially the same or similar to components of the second gate driver GDV2 of FIG. 1. For example, the second gate driver GDV2 of FIG. 1 may also include gate stages. Components of the first connection part CP1 of FIG. 2 may be substantially the same or similar to components of the second connection part CP2 of FIG. 1. For example, the second connection part CP2 of FIG. 1 may also include sub-connection parts. The gate stages of the second gate driver GDV2 of FIG. 1 may be electrically connected to the first and second pixel structures PX1 and PX2 through a connection line, a sub-connection part of the second connection part CP2, and a gate signal line, respectively.

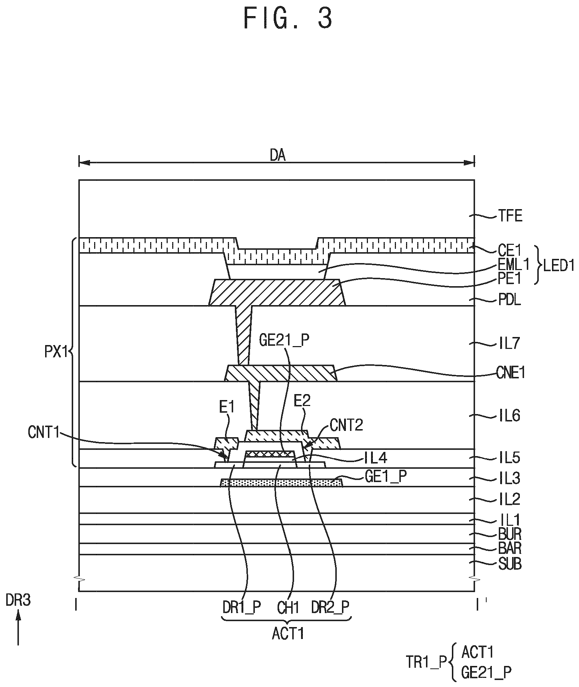

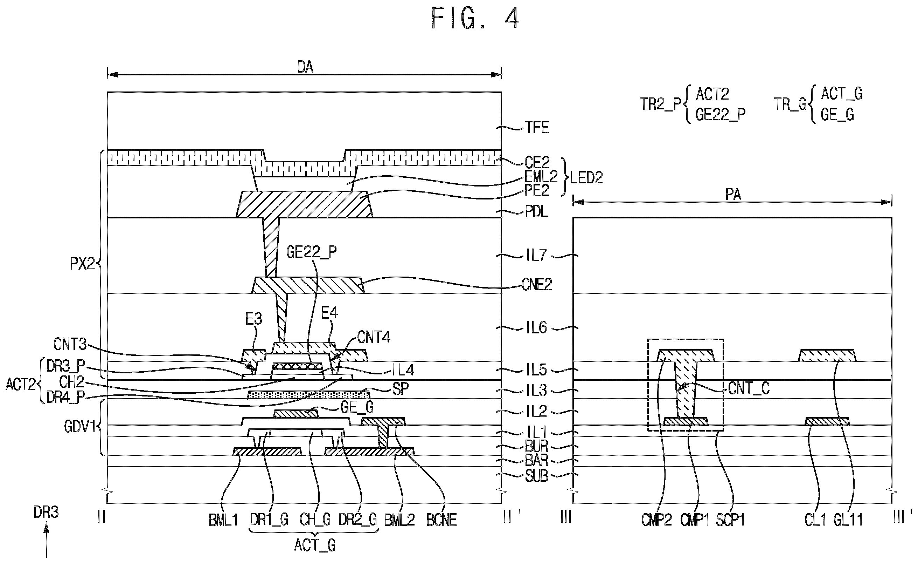

FIG. 3 is a schematic cross-sectional view taken along line I-I' of FIG. 1. FIG. 4 is a schematic cross-sectional view showing an embodiment of a cross section taken along lines II-II' and III-III' of FIG. 2.

For example, FIG. 3 shows the first pixel structure PX1 of FIG. 1, and FIG. 4 shows the second pixel structure PX2, the first gate driver GDV1 (for example, the first gate stage GST1 of FIG. 2), and the first connection part CP1 (for example, the first sub-connection part SCP1 of FIG. 2) of FIG. 2. The cross-sectional structures of the first, second, third, fourth, fifth, sixth, seventh, and eighth gate stages GST1, GST2, GST3, GST4, GST5, GST6, GST7, and GST8 of FIG. 2 may be substantially the same, and the first, second, third, fourth, fifth, sixth, seventh, and eighth sub-connection part SCP1, SCP2, SCP3, SCP4, SCP5, SCP6, SCP7, and SCP8 of FIG. 2 may be substantially the same. The cross-sectional structure of the second gate driver GDV2 may be substantially the same as the cross-sectional structure of the first gate driver GDV1, and the cross-sectional structure of the second connection part CP2 may be substantially the same as the cross-sectional structure of the first connection part CP1.

Referring to FIGS. 3 and 4, the display device DD according to an embodiment may include a substrate SUB, a barrier layer BAR, a buffer layer BUR, a first lower metal layer BML1, a second lower metal layer BML2, a driver transistor TR_G, a connection pattern BCNE, the first sub-connection part SCP1, the first connection line CL1, the first-first gate signal line GL11, a shielding pattern SP, a first pixel gate electrode GE1_P, first and second pixel transistors TR1_P, and TR2_P, first, second, third, and fourth electrodes E1, E2, E3, and E4, first and second connection electrodes CNE1 and CNE2, first, second, third, fourth, fifth, sixth, and seventh insulating layers IL1, IL2, IL3, IL4, IL5, IL6, and IL7, a pixel defining layer PDL, first and second light emitting elements LED1 and LED2, and encapsulation layer TFE.

Here, the driver transistor TR_G may include a driver active layer ACT_G and a driver gate electrode GE_G, the first pixel transistor TR1_P may include a first pixel active layer ACT1 and a second-first pixel gate electrode GE21_P, and the second pixel transistor TR2_P may include a second pixel active layer ACT2 and a second-second pixel gate electrode GE22_P. The first light emitting element LED1 may include a first pixel electrode PE1, a first light emitting layer EML1, and a first common electrode CE1, and the second light emitting element LED2 may include a second pixel electrode PE2, a second light emitting layer EML2, and a second common electrode CE2.

As described above, the display device DD may be divided into the display area DA and the peripheral area PA. As the display device DD is divided into the display area DA and the peripheral area PA, the components of the display device DD (for example, the substrate SUB and the like) may include the display area DA and the peripheral area PA.

The substrate SUB may include a transparent material or an opaque material. The substrate SUB may be made of a transparent resin substrate. Examples of the transparent resin substrate include a polyimide substrate. In this case, the polyimide substrate may include a first organic layer, a first barrier layer, a second organic layer, and the like within the scope of the disclosure. By way of example, the substrate SUB may include a quartz substrate, synthetic quartz substrate, calcium fluoride substrate, F-doped quartz substrate, a soda-lime glass substrate, a non-alkali glass substrate, and the like within the scope of the disclosure. These can be used alone or in combination with each other.

The barrier layer BAR may be disposed on the substrate SUB. The barrier layer BAR may prevent the penetration of unnecessary components such as impurities or moisture. The barrier layer BAR may include an inorganic material such as silicon oxide (SiOₓ), silicon nitride (SiNₓ), silicon oxynitride (SiOₓN_{y}), and the like within the scope of the disclosure. These can be used alone or in combination with each other.

The first lower metal layer BML1 may be disposed in the display area DA on the barrier layer BAR. Various electrical signals and/or voltages may be applied to the first lower metal layer BML1. For example, the first lower metal layer BML1 may include metal, alloy metal nitride, conductive metal oxide, transparent conductive material, and the like within the scope of the disclosure. Examples of the metal may include silver (Ag), molybdenum (Mo), aluminum (Al), tungsten (W), copper (Cu), nickel (Ni), chromium (Cr), titanium (Ti), tantalum (Ta), platinum (Pt), scandium (Sc), and the like within the scope of the disclosure. Examples of the conductive metal oxide may include indium tin oxide, indium zinc oxide, and the like within the scope of the disclosure. Examples of the metal nitride may include aluminum nitride (AlNₓ), tungsten nitride (WNₓ), chromium nitride (CrNₓ), and the like within the scope of the disclosure. Each of these can be used alone or in combination with each other.

The second lower metal layer BML2 may be disposed in the display area DA on the barrier layer BAR. The second lower metal layer BML2 may be disposed in the same layer as the first lower metal layer BML1. For example, the second lower metal layer BML2 may include the same material as the first lower metal layer BML2 and may be formed through the same process.

The buffer layer BUR may be disposed on the barrier layer BAR. The buffer layer BUR may cover the first lower metal layer BML1 and the second lower metal layer BML2. The buffer layer BUR may prevent metal atoms or impurities from diffusing from the substrate SUB to a transistor. The buffer layer BUR may improve the flatness of the surface of the substrate SUB in case that the surface of the substrate SUB is not uniform. For example, the buffer layer BUR may include an inorganic material such as silicon oxide (SiOₓ), silicon nitride (SiNₓ), silicon oxynitride (SiOₓN_{y}), and the like within the scope of the disclosure. These can be used alone or in combination with each other.

The driver active layer ACT_G may be disposed in the display area DA on the buffer layer BUR. In an embodiment, the driver active layer ACT_G may include a silicon semiconductor (for example, amorphous silicon, poly silicon, and the like within the scope of the disclosure). However, embodiments are not limited to this, and the driver active layer ACT_G may include a metal oxide semiconductor or an organic semiconductor.

The driver active layer ACT_G may include a first doped region DR1_G, a channel region CH_G, and a second doped region DR2_G) The channel region CH_G may be located between the first doped region DR1_G and the second doped region DR2_G. For example, each of the first doped region DR1_G and the second doped region DR2_G may be doped with a p-type impurity. By way of example, each of the first doped region DR1_G and the second doped region DR2_G may be doped with an N-type impurity. The channel region CH_G may not be doped with impurities.

The first doped region DR1_G of the driver active layer ACT _G may be connected to the first lower metal layer BML1 through a contact hole penetrating the buffer layer BUR. The second doped region DR2_G of the driver active layer ACT_G may be connected to the second lower metal layer BML2 through a contact hole penetrating the buffer layer BUR.

The first insulating layer IL1 may be disposed on the buffer layer BUR. The first insulating layer IL1 may cover the driver active layer ACT _G. For example, the first insulating layer IL1 may cover the driver active layer ACT_G and may be disposed along the profile of the driver active layer ACT_G with a uniform thickness. By way of example, the first insulating layer IL1 may sufficiently cover the driver active layer ACT_G and may have a substantially flat upper surface without creating a step around the driver active layer ACT_G. For example, the first insulating layer IL1 may include an inorganic material such as silicon oxide, silicon nitride, silicon oxynitride, and the like within the scope of the disclosure. These can be used alone or in combination with each other.

The driver gate electrode GE_G may be disposed in the display area DA on the first insulating layer IL1. The driver gate electrode GE_G may overlap the channel region CH_G of the driver active layer ACT_G in the plan view. For example, the driver gate electrode GE_G may include metal, alloy metal nitride, conductive metal oxide, transparent conductive material, and the like within the scope of the disclosure. These can be used alone or in combination with each other.

Accordingly, the driver transistor TR_G including the driver active layer ACT_G and the driver gate electrode GE_G may be disposed in the display area DA on the substrate SUB.

The connection pattern BCNE may be disposed in the display area DA on the first insulating layer IL1. The connection pattern BCNE may be connected to the second lower metal layer BML2 through a contact hole penetrating the buffer layer BUR and the first insulating layer IL1. The connection pattern BCNE may be disposed in the same layer as the driver gate electrode GE_G. For example, the connection pattern BCNE may include the same material as the driver gate electrode GE_G and may be formed through the same process.

The first lower metal layer BML1, the second lower metal layer BML2, the driver transistor TR_G, and the connection pattern BCNE may constitute a portion of the first gate driver GDV1. For example, the first lower metal layer BML1, the second lower metal layer BML2, the driver transistor TR_G, and the connection pattern BCNE may be included to the first gate driver GDV1 (for example, the first gate stage GST1 of FIG. 2).

The second insulating layer IL2 may be disposed on the first insulating layer IL1. The second insulating layer IL2 may cover the driver gate electrode GE_G and the connection pattern BCNE. For example, the second insulating layer IL2 may sufficiently cover the driver gate electrode GE_G and have a substantially flat upper surface without creating a step around the driver gate electrode GE_G and the connection pattern BCNE. By way of example, the second insulating layer IL2 may cover the driver gate electrode GE_G and the connection pattern BCNE and be disposed along each of the profile of the driver gate electrode GE_G and the connection pattern BCNE with a uniform thickness. For example, the second insulating layer IL2 may include an inorganic material such as silicon oxide, silicon nitride, silicon oxynitride, and the like within the scope of the disclosure. These can be used alone or in combination with each other.

The first pixel gate electrode GE1_P may be disposed in the display area DA on the second insulating layer IL2. The first pixel gate electrode GE1_P may be disposed to at least partially overlap the first pixel transistor TR1_P in the plan view. For example, the first pixel gate electrode GE1_P may include metal, alloy metal nitride, conductive metal oxide, transparent conductive material, and the like within the scope of the disclosure. These can be used alone or in combination with each other.

The shielding pattern SP may be disposed in the display area DA on the second insulating layer IL2. The shielding pattern SP may be disposed in the same layer as the first pixel gate electrode GE1_P. For example, the shielding pattern SP may include the same material as the first pixel gate electrode GE1_P and may be formed through the same process. In an embodiment, the shielding pattern SP may be disposed between the first gate driver GDV1 and the second pixel structure PX2. The shielding pattern SP may at least partially overlap the driver transistor TR_G in the plan view. The shielding pattern SP may shield the influence of the electrical signal applied to the first gate driver GDV1 on the second pixel structure PX2 and the influence of the electrical signal applied to the second pixel structure PX2 on the first gate driver GDV1.

The third insulating layer IL3 may be disposed on the second insulating layer IL2. The third insulating layer IL3 may cover the first pixel gate electrode GE1_P and the shielding pattern SP. For example, the third insulating layer IL3 may sufficiently cover the first pixel gate electrode GE1_P and have a substantially flat upper surface without creating a step around the first pixel gate electrode GE1_P and the shielding pattern SP. By way of example, the third insulating layer IL3 may cover the first pixel gate electrode GE1_P and the shielding pattern SP, and be disposed along the profile of each of the first pixel gate electrode GE1_P and the shielding pattern SP with a uniform thickness. For example, the third insulating layer IL3 may include an inorganic material such as silicon oxide, silicon nitride, silicon oxynitride, and the like within the scope of the disclosure. These can be used alone or in combination with each other.

The first pixel active layer ACT1 may be disposed in the display area DA on the third insulating layer IL3. In an embodiment, the first pixel active layer ACT1 may include a metal oxide semiconductor. The metal oxide semiconductor may include a binary compound (ABₓ), a ternary compound (ABₓC_{y}), a quaternary compound (ABₓC_{y}D_{z}), and the like containing indium (In), zinc (Zn), gallium (Ga), tin (Sn), titanium (Ti), aluminum (Al), hafnium (Hf), zirconium (Zr), magnesium (Mg), and the like within the scope of the disclosure. For example, the metal oxide semiconductor may include zinc oxide (ZnOₓ), gallium oxide (GaOₓ), tin oxide (SnOₓ), indium oxide (InOₓ), indium gallium oxide (IGO), indium zinc oxide (IZO), indium tin oxide. (ITO), indium zinc tin oxide (IZTO), indium gallium zinc oxide (IGZO), and the like within the scope of the disclosure. These can be used alone or in combination with each other. However, embodiments are not limited to this, and the first pixel active layer ACT1 may include a silicon semiconductor or an organic semiconductor.

The first pixel active layer ACT1 may include a first doped region DR1_P, a first channel region CH1, and a second doped region DR2_P. The first channel region CH1 may be located between the first doped region DR1_P and the second doped region DR2_P. For example, each of the first doped region DR1_P and the second doped region DR2_P may be doped with an N-type impurity. By way of example, each of the first doped region DR1_P and the second doped region DR2_P may be doped with a P-type impurity. The first channel region CH1 may not be doped with impurities.

The second pixel active layer ACT2 may be disposed in the display area DA on the third insulating layer IL3. The second pixel active layer ACT2 may be disposed in the same layer as the first pixel active layer ACT1. For example, the second pixel active layer ACT2 may include the same material as the first pixel active layer ACT1 and may be formed through the same process.

The second pixel active layer ACT2 may include a third doped region DR3_P, a second channel region CH2, and a fourth doped region DR4_P. The second channel region CH2 may be located between the third doped region DR3_P and the fourth doped region DR4_P. For example, each of the third doped region DR3_P and the fourth doped region DR4_P may be doped with an N-type impurity. By way of example, each of the third doped region DR3_P and the fourth doped region DR4_P may be doped with a P-type impurity. The second channel region CH2 may not be doped with impurities.

The fourth insulating layer IL4 may be disposed on the first pixel active layer ACT1 and the second pixel active layer ACT2, respectively. The fourth insulating layer IL4 may not overlap the first, second, third, and fourth doped regions DR1_P, DR2_P, DR3_P, and DR4_P in the plan view and may overlap the first and second channel regions CH1 and CH2 in the plan view. For example, the fourth insulating layer IL4 may include an inorganic material such as silicon oxide, silicon nitride, silicon oxynitride, and the like within the of the disclosure. These can be used alone or in combination with each other.

The second-first pixel gate electrode GE21_P may be disposed on the fourth insulating layer IL4. The second-first pixel gate electrode GE21_P may overlap the fourth insulating layer IL4 and the first channel region CH1 in the plan view. For example, the second-first pixel gate electrode GE21_P may include metal, alloy metal nitride, conductive metal oxide, transparent conductive material, and the like within the scope of the disclosure. These can be used alone or in combination with each other.

Accordingly, the first pixel transistor TR1_P including the first pixel active layer ACT1 and the second-first pixel gate electrode GE21_P may be disposed in the display area DA on the substrate SUB.

The second-second pixel gate electrode GE22_P may be disposed on the fourth insulating layer IL4. The second-second pixel gate electrode GE22_P may overlap the fourth insulating layer IL4 and the second channel region CH2 in the plan view. The second-second pixel gate electrode GE22_P may be disposed on the same layer as the second-first pixel gate electrode GE21_P. For example, the second-second pixel gate electrode GE22_P may include the same material as the second-first pixel gate electrode GE21_P and may be formed through the same process as the second-first pixel gate electrode GE21_P.

Accordingly, the second pixel transistor TR2_P including the second pixel active layer ACT2 and the second-second pixel gate electrode GE22_P may be disposed in the display area DA on the substrate SUB. The second pixel transistor TR2_P may at least partially overlap the driver transistor TR_G in the plan view.

The fifth insulating layer IL5 may be disposed on the third insulating layer IL3, the first pixel active layer ACT1, the second pixel active layer ACT2, and the fourth insulating layer IL4. The fifth insulating layer IL5 may cover the first pixel active layer ACT1, the second pixel active layer ACT2, and the fourth insulating layer IL4. For example, the fifth insulating layer IL5 may cover the first pixel active layer ACT1, the second pixel active layer ACT2, and the fourth insulating layer IL4, and be disposed along each of the profile of the first pixel active layer ACT1, the second pixel active layer ACT2, and the fourth insulating layer IL4 with a uniform thickness. Accordingly, the fifth insulating layer IL5 may sufficiently cover the first pixel active layer ACT1, the second pixel active layer ACT2, and the fourth insulating layer IL4, and have a substantially flat upper surface without creating a step around the first pixel active layer ACT1, the second pixel active layer ACT2, and the fourth insulating layer IL4. For example, the fifth insulating layer IL5 may include an inorganic material such as silicon oxide, silicon nitride, silicon oxynitride, and the like within the scope of the disclosure. These can be used alone or in combination with each other.

The first, second, third, and fourth electrodes E1, E2, E3, and E4 may be disposed in the display area DA on the fifth insulating layer IL5. The first electrode E1 may be connected to the first doped region DR1_P of the first pixel active layer ACT1 through a first contact hole CNT1 penetrating the fifth insulating layer IL5, and the second electrode E2 may be connected to the second doped region DR2_P of the first pixel active layer ACT2 through a second contact hole CNT2 penetrating the fifth insulating layer IL5. The third electrode E3 may be connected to the third doped region DR3_P of the second pixel active layer ACT2 through a third contact hole CNT3 penetrating the fifth insulating layer IL5, and the fourth electrode E4 may be connected to the fourth doped region DR4_P of the second pixel active layer ACT2 through a fourth contact hole CNT4 penetrating the fifth insulating layer IL5. For example, the first, second, third, and fourth electrodes E1, E2, E3, and E4 may include metal, alloy metal nitride, conductive metal oxide, transparent conductive material, and the like within the scope of the disclosure. These can be used alone or in combination with each other.

The first sub-connection part SCP1 of the first connection part CP1 may include at least one conductive pattern. For example, the first sub-connection part SCP1 of the first connection part CP1 may include a first conductive pattern CMP1 and a second conductive pattern CMP2 disposed on the first conductive pattern CMP1. In an embodiment, the first conductive pattern CMP1 may be disposed in the same layer as the driver gate electrode GE_G, and the second conductive pattern CMP2 may be disposed in the same layer as the first, second, third, and fourth electrodes E1, E2, E3, and E4. For example, the first conductive pattern CMP1 may include the same material as the driver gate electrode GE_G and may be formed through the same process as the driver gate electrode GE_G. The second conductive pattern CMP2 may include the same material as the first, second, third, and fourth electrodes E1, E2, E3, and E4, and may be formed through the same process as the first, second, third, and fourth electrodes E1, E2, E3, and E4. However, embodiments are not limited thereto.

In an embodiment, the second conductive pattern CMP2 may be connected to the first conductive pattern CMP1 through a contact hole CNT_C penetrating the second insulating layer IL2, the third insulating layer IL3, and the fifth insulating layer IL5. The first connection line CL1 may extend from the first conductive pattern CMP1, and the first-first gate signal line GL11 may extend from the second conductive pattern CMP2. For example, the first connection line CL1 may be integral with the first conductive pattern CMP1, and the first-first gate signal line GL11 may be integral with the second conductive pattern CMP2. In other words, the first connection line CL1 may be disposed in the same layer as the first conductive pattern CMP1, and the first-first gate signal line GL11 may be disposed in the same layer as the second conductive pattern CMP2.

An area or a size or diameter of each of the first, second, third, and fourth contact holes CNT1, CNT2, CNT3, and CNT4 and an area of the contact hole CNT_C may be different. In an embodiment, the area of the contact hole CNT_C may be larger than the area of each of the first, second, third, and fourth contact holes CNT1, CNT2, CNT3, and CNT4. Accordingly, electrical connection between the first gate driver GDV1 and the pixel structures PX1 and PX2 may be facilitated.

The sixth insulating layer IL6 may be disposed on the fifth insulating layer IL5. The sixth insulating layer IL6 may sufficiently cover the first, second, third, and fourth electrodes E1, E2, E3, and E4, the second conductive pattern CMP2, and the first-first gate signal line GL11. The sixth insulating layer IL6 may have a substantially flat upper surface. For example, the sixth insulating layer IL6 may include an organic material such as phenolic resin, polyacrylates resin, polyimides rein, polyamides resin, siloxane resin, epoxy resin, and the like within the scope of the disclosure. These can be used alone or in combination with each other.

The first and second connection electrodes CNE1 and CNE2 may be disposed in the display area DA on the sixth insulating layer IL6. The first connection electrode CNE1 may be connected to the second electrode E2 (or the first electrode E1) through a contact hole penetrating the sixth insulating layer IL6. The second connection electrode CNE2 may be connected to the fourth electrode E4 (or the third electrode E3) through a contact hole penetrating the sixth insulating layer IL6. For example, the first and second connection electrodes CNE1 and CNE2 may include metal, alloy metal nitride, conductive metal oxide, transparent conductive material, and the like within the scope of the disclosure. These can be used alone or in combination with each other.

The seventh insulating layer IL7 may be disposed on the sixth insulating layer IL6. The seventh insulating layer IL7 may sufficiently cover the first and second connection electrodes CNE1 and CNE2. The seventh insulating layer IL7 may have a substantially flat upper surface. For example, the seventh insulating layer IL7 may include an organic material such as phenol resin, acrylic resin, polyimide resin, polyamide resin, siloxane resin, epoxy resin, and the like within the scope of the disclosure. These can be used alone or in combination with each other.

The first and second pixel electrodes PE1 and PE2 may be disposed in the display area DA on the seventh insulating layer IL7. The first pixel electrode PE1 may be connected to the first connection electrode CNE1 through a contact hole penetrating the seventh insulating layer IL7. The second pixel electrode PE2 may be connected to the second connection electrode CNE2 through a contact hole penetrating the seventh insulating layer IL7. For example, the first and second pixel electrodes PE1 and PE2 may include metal, alloy metal nitride, conductive metal oxide, transparent conductive material, and the like within the scope of the disclosure. These can be used alone or in combination with each other. The first and second pixel electrodes PF1 and PE2 may each be an anode electrode.

The pixel defining layer PDL may be disposed in the display area DA on the seventh insulating layer IL7. The pixel defining layer PDL may cover the edges of each of the first and second pixel electrodes PE1 and PE2. A pixel opening exposing at least a portion of each of the first and second pixel electrodes PE1 and PE2 may be defined in the pixel defining layer PDL. For example, the pixel defining layer PDL may include an organic material such as epoxy resin, siloxane resin, and the like within the scope of the disclosure. These can be used alone or in combination with each other. By way of example, the pixel defining layer PDL may include an inorganic material.

The first emitting layer EML1 may be disposed on the first pixel electrode PE1, and the second emitting layer EML2 may be disposed on the second pixel electrode PE2. Each of the first light emitting layer EML1 and the second light emitting layer EML2 may include a light emitting material that generates light of a preset color (for example, red, green, or blue).

The first and second common electrodes CE1 and CE2 may be disposed on the pixel defining layer PDL, the first light emitting layer EML1, and the second emitting layer EML2. The first common electrode CE1 may be integral with the second common electrode CE2. For example, the first and second common electrodes CE1 and CE2 may include metal, alloy metal nitride, conductive metal oxide, transparent conductive material, and the like within the scope of the disclosure. These can be used alone or in combination with each other. Each of the first and second common electrodes CE1 and CE2 may be a cathode electrode.

Accordingly, the first light emitting element LED1 including the first pixel electrode PE1, the first light emitting layer EML1, and the first common electrode CE1 may be disposed in the display area DA on the substrate SUB, and the second light emitting element LED2 including the second pixel electrode PE1, the second light emitting layer EML2, and the second common electrode CE2 may be disposed in the display area DA on the substrate SUB.

The first pixel transistor TR1_P and the first light emitting element LED1 may constitute a portion of the first pixel structure PX1, and the second pixel transistor TR2_P and the second light emitting element LED2 may constitute a portion of the second pixel structure PX2. For example, the first pixel transistor TR1_P and the first light emitting element LED1 may be included in the first pixel structure PX1, and the second pixel transistor TR2_P and the second light emitting element LED2 may be included in the second pixel structure PX2.

The encapsulation layer TFE may be disposed in the display area DA on the first and second common electrodes CE1 and CE2. Although not shown in detail in FIG. 4, the encapsulation layer TFE may also be disposed in a portion of the peripheral area PA. The encapsulation layer TFE may prevent impurities, moisture, external air, and the like from penetrating into the first and second light emitting elements LED1 and LED2 from the outside. The encapsulation layer TFE may include at least one inorganic layer and at least one organic layer. For example, the inorganic layer may include silicon oxide, silicon nitride, silicon oxynitride, and the like within the scope of the disclosure. These can be used alone or in combination with each other. The organic layer may include a cured polymer such as polyacrylate and the like within the scope of the disclosure.

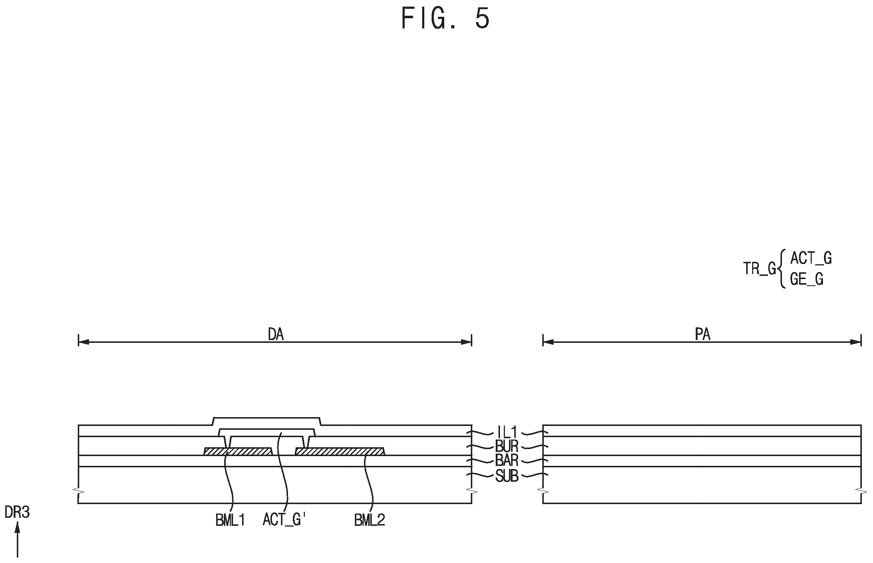

FIGS. 5, 6, 7, 8, 9, 10, and 11 are schematic cross-sectional views for explaining a method for manufacturing the display device of FIG. 4. Hereinafter, content that overlaps with the content described with reference to FIG. 4 may be omitted or simplified.

Referring to FIG. 5, the barrier layer BAR may be formed on the substrate SUB. The barrier layer BAR may be formed in the display area DA and the peripheral area PA.

The first lower metal layer BML1 and the second lower metal layer BML2 may be formed in the display area DA on the barrier layer BAR. The buffer layer BUR covering the first lower metal layer BML1 and the second lower metal layer BML2 may be formed on the barrier layer BAR. The buffer layer BUR may be formed in the display area DA and the peripheral area PA.

A preliminary driver active layer ACT_G' may be formed on the buffer layer BUR. The preliminary driver active layer ACT_G' may be connected to the first lower metal layer BML1 and the second lower metal layer BML2 through contact holes formed by removing a portion of the buffer layer BUR. In an embodiment, the preliminary driver active layer ACT_G' may be formed using polysilicon. The first insulating layer IL1 may be formed on the buffer layer BUR. The first insulating layer IL1 may be formed in the display area DA and the peripheral area PA.

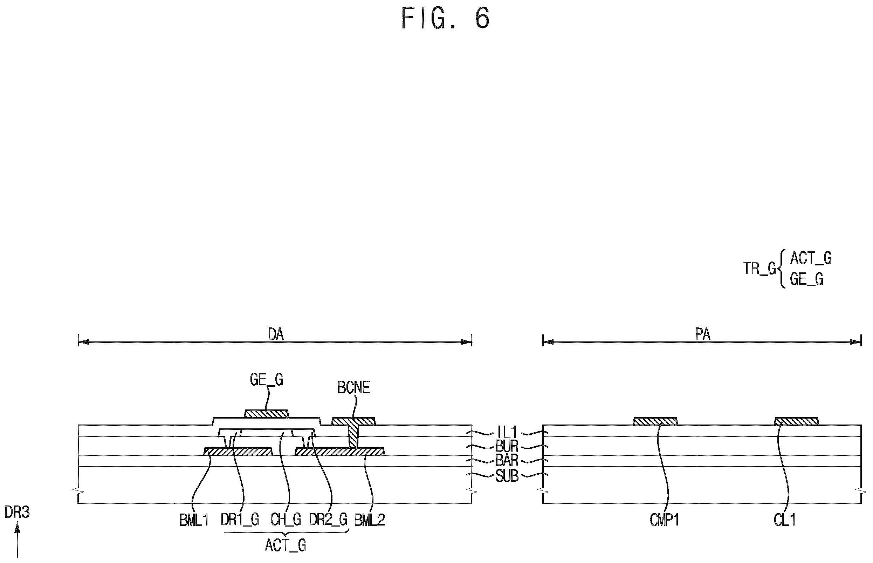

Referring further to FIG. 6, the driving gate electrode GE_G and the connection pattern BCNE may be formed in the display area DA on the first insulating layer IL1 through the same process. The connection pattern BCNE may be connected to the second lower metal layer BML2 through a contact hole formed by removing a portion of the buffer layer BUR and the first insulating layer IL1.

The first conductive pattern CMP1 and the first connection line CL1 may be formed in the peripheral area PA on the first insulating layer IL1. The first conductive pattern CMP1 and the first connection line CL1 may be formed through the same process as the driver gate electrode GE_G and the connection pattern BCNE.

The preliminary driver active layer ACT_G' may be doped using the driver gate electrode GE_G as a mask. Accordingly, the driver active layer ACT_G including the first and second doped regions DR1_G and DR2_G doped with impurities (for example, P-type impurities) and the channel region CH_G that is not doped with impurities may be formed.

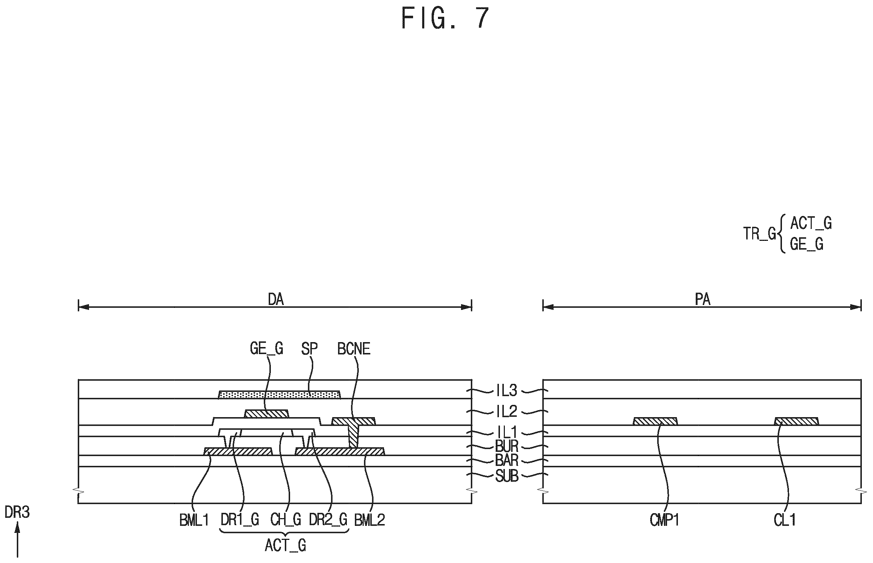

Referring further to FIG. 7, the second insulating layer IL2 may be formed on the first insulating layer IL1. The second insulating layer IL2 may be formed in the display area DA and the peripheral area PA. The second insulating layer IL2 may cover the driver gate electrode GE_G, the connection pattern BCNE, the first conductive pattern CMP1, and the first connection line CL1.

The shielding pattern SP may be formed in the display area DA on the second insulating layer IL2. The shielding pattern SP may be formed to cover at least a portion of the driver transistor TR_G. The third insulating layer IL3 may be formed on the second insulating layer IL2. The third insulating layer IL3 may be formed in the display area DA and the peripheral area PA. The third insulating layer IL3 may cover the shielding pattern SP.

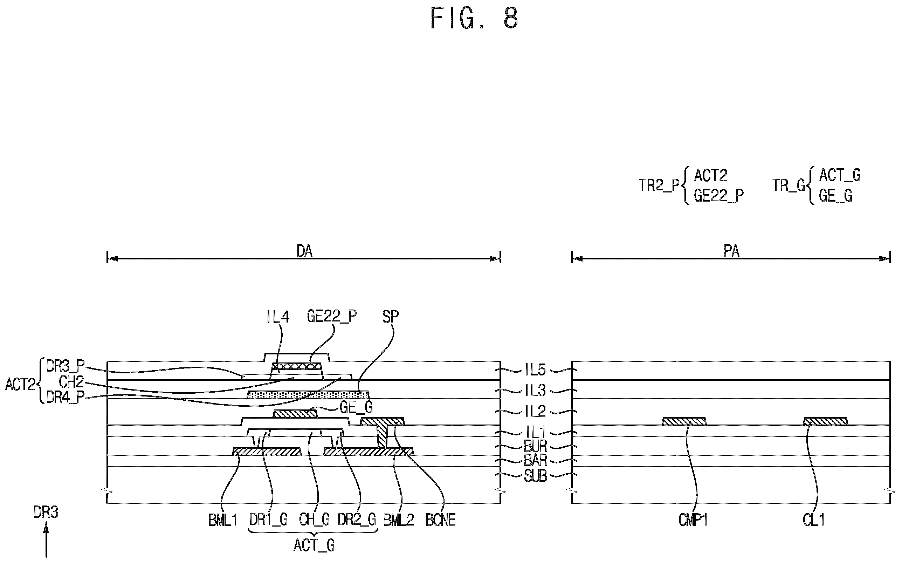

Referring further to FIG. 8, the second pixel active layer ACT2 may be formed in the display area DA on the third insulating layer IL3. In an embodiment, the second pixel active layer ACT2 may be formed using a metal oxide semiconductor.

The fourth insulating layer IL4 may be formed on the second pixel active layer ACT2. The fourth insulating layer IL4 may be patterned to overlap a portion of the second pixel active layer ACT2. During the process of patterning the fourth insulating layer IL4, hydrogen may flow into the second pixel active layer ACT2. In this case, the portion of the second pixel active layer ACT2 into which hydrogen flows has an increased carrier concentration due to the introduced hydrogen and becomes conductive, so that the second pixel active layer ACT2 may include the third and fourth doped regions DR3 and DR4 doped with impurities (for example, an N-type impurity) and the second channel region CH2 that is not doped with impurities.

The second-second pixel gate electrode GE22_P may be formed in the display area DA on the fourth insulating layer IL4. The second-second pixel gate electrode GE22_P may be patterned to overlap the second channel region CH2 of the second pixel active layer ACT2. A fifth insulating layer IL5 may be formed on the second pixel active layer ACT2, the fourth insulating layer IL4, and the second-second pixel gate electrode GE22_P. The fifth insulating layer IL5 may be formed in the display area DA and the peripheral area PA.

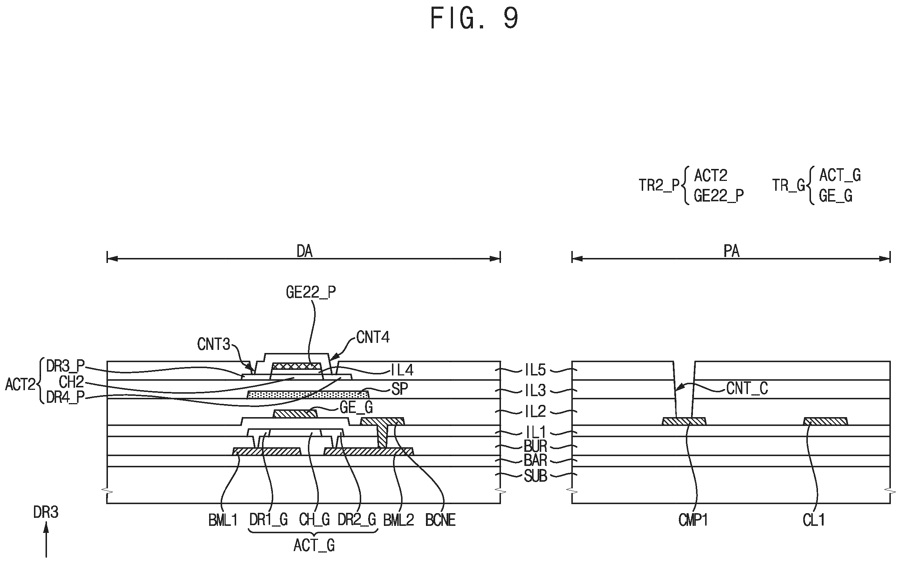

Referring further to FIG. 9, in the display area DA, the third contact hole CNT3 exposing the third doped region DR3_P and the fourth contact hole CNT4 exposing the fourth doped region DR4_P may be formed by removing a portion of the fifth insulating layer IL5. At the same time, in the peripheral area PA, the contact hole CNT_C exposing the first conductive pattern CMP1 may be formed by removing portions of the second insulating layer IL2, the third insulating layer IL3, and the fifth insulating layer IL5.

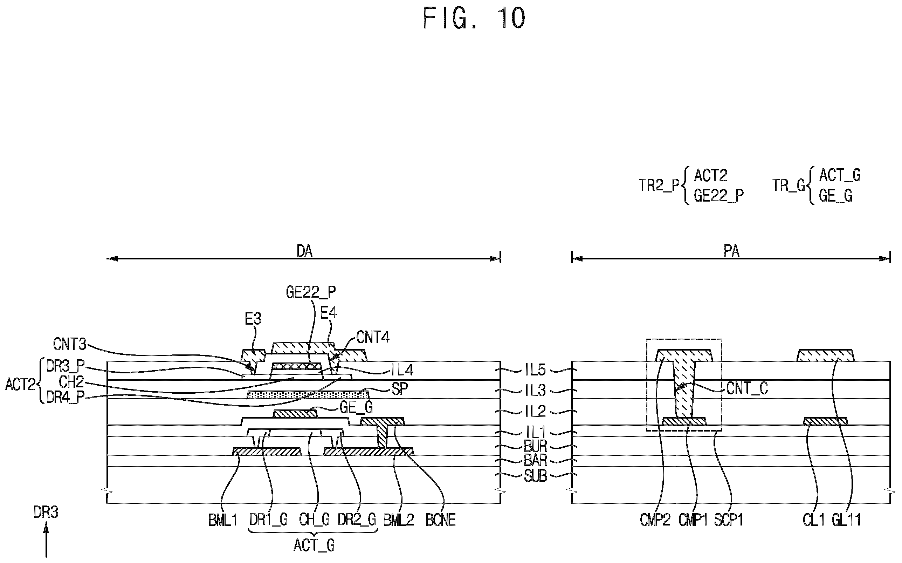

Referring further to FIG. 10, the third electrode E3 may be formed to fill the third contact hole CNT3, the fourth electrode E4 may be formed to fill the fourth contact hole CNT4, and the second conductive pattern CMP2 may be formed to fill the contact hole CNT_C. At the same time, the first-first gate signal line GL11 may be formed in the peripheral area PA on the fifth insulating layer IL5.

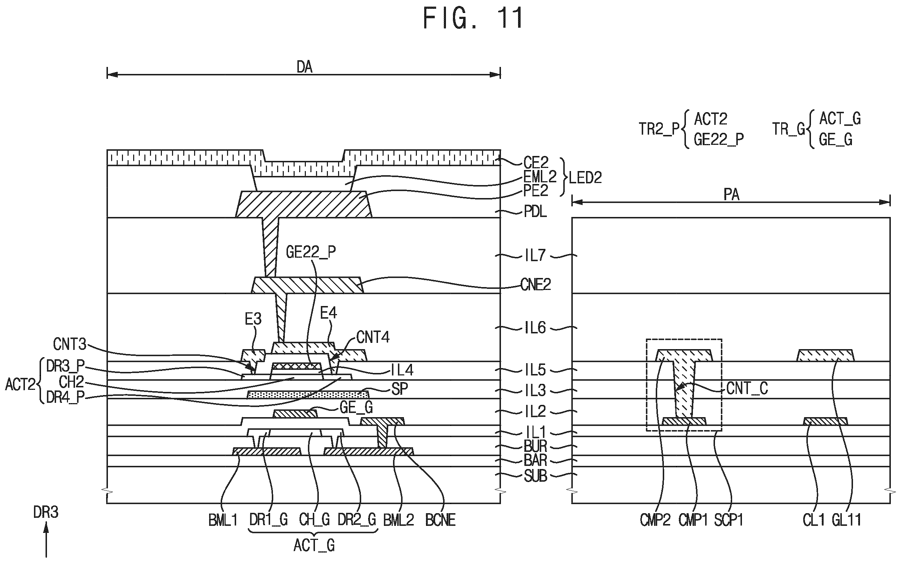

Referring further to FIG. 11, the sixth insulating layer IL6 covering the fourth electrode E4, the second conductive pattern CMP2, and the first-first gate signal line GL11 may be formed on the fifth insulating layer IL5. The sixth insulating layer IL6 may be formed in the display area DA and the peripheral area PA.

The second connection electrode CNE2 may be formed in the display area DA on the sixth insulating layer IL6. The second connection electrode CNE2 may be connected to the fourth electrode E4 through a contact hole formed by removing a portion of the sixth insulating layer IL6. The seventh insulating layer IL7 covering the second connection electrode CNE2 may be formed on the sixth insulating layer IL6. The seventh insulating layer IL7 may be formed in the display area DA and the peripheral area PA.

The second pixel electrode PE2 may be formed in the display area DA on the seventh insulating layer IL7. The second pixel electrode PE2 may be connected to the second connection electrode CNE2 through a contact hole formed by removing a portion of the seventh insulating layer IL7. The pixel defining layer PDL exposing at least a portion of the second pixel electrode PE2 may be formed in the display area DA on the seventh insulating layer IL7. The second light emitting layer EML2 may be formed in the pixel opening of the pixel defining layer PDL. The second common electrode CE2 may be formed on the second light emitting layer EML2 and the pixel defining layer PDL.

Referring again to FIG. 4, the encapsulation layer TFE may be formed on the second common electrode CE2.

Accordingly, the display device DD shown in FIG. 4 may be manufactured.

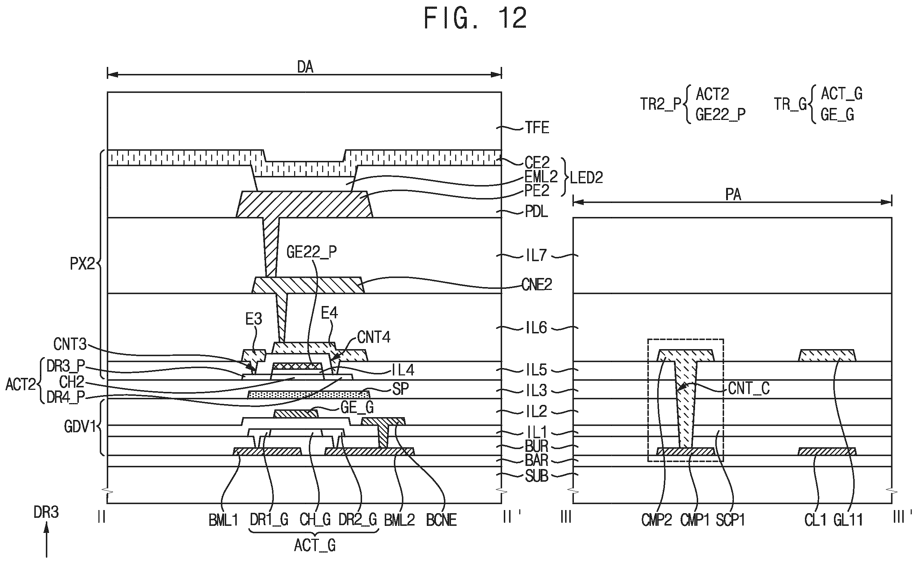

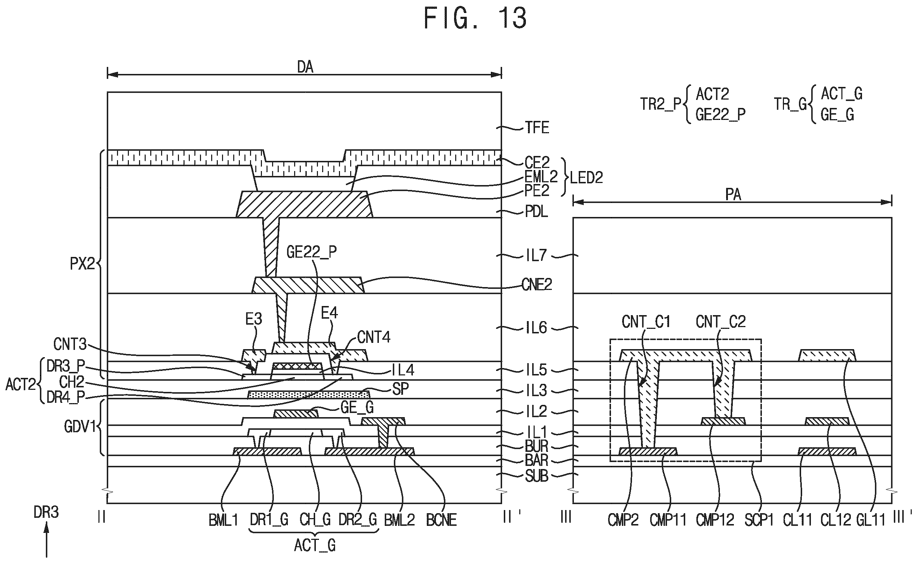

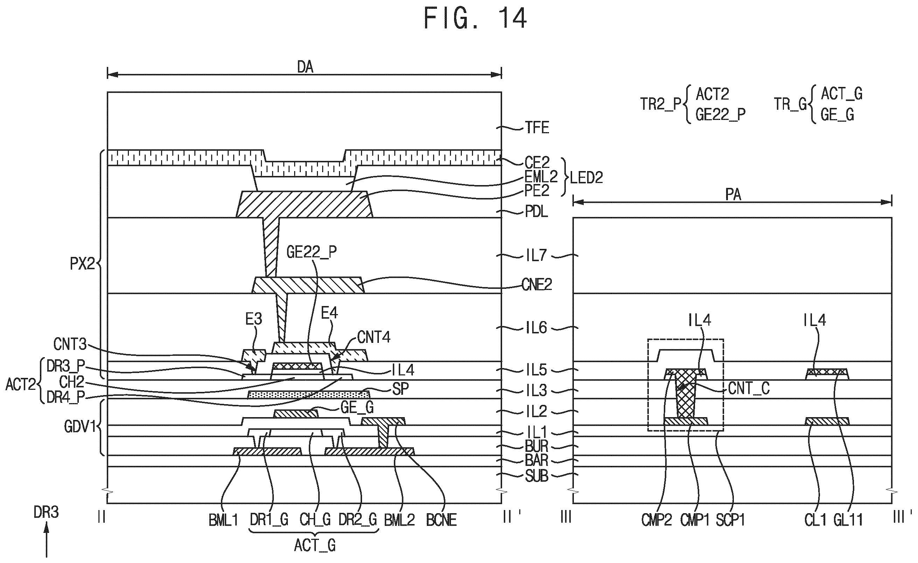

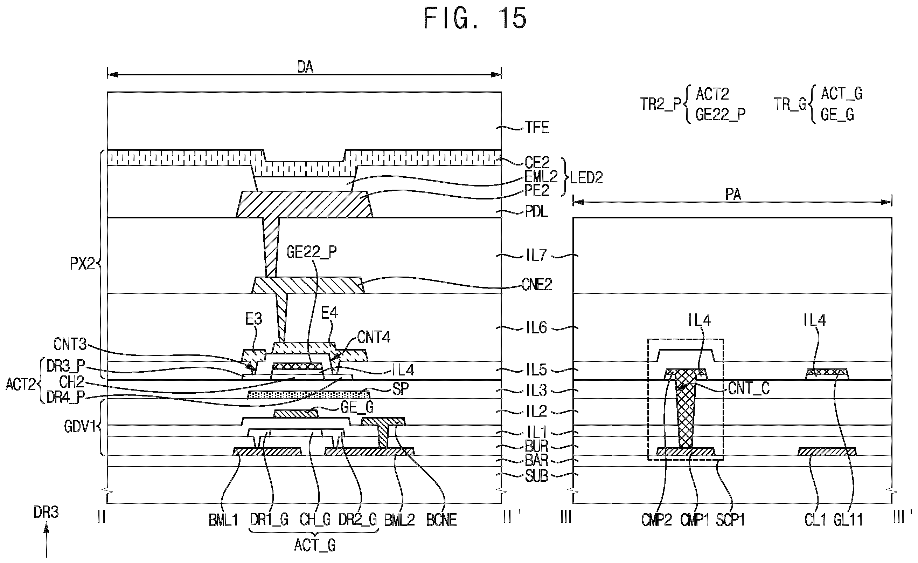

FIG. 12 is a schematic cross-sectional view showing an embodiment of a cross section taken along lines II-II' and III-III' of FIG. 2. FIG. 13 is a schematic cross-sectional view showing an embodiment of a cross section taken along lines II-II' and III-III' of FIG. 2. FIG. 14 is a schematic cross-sectional view showing an embodiment of a cross section taken along lines II-II' and III-III' of FIG. 2. FIG. 15 is a cross-sectional view showing an embodiment of a cross section taken along lines II-II' and III-III' of FIG. 2.

The display device described with reference to FIGS. 12, 13, 14, and 15 may be substantially the same as or similar to the display device DD described with reference to FIGS. 3 and 4 except for the cross-sectional structure of the peripheral area PA. Hereinafter, overlapping descriptions may be omitted or simplified.

Referring to FIG. 12, the first sub-connection part SCP1 of the first connection part CP1 may include at least one conductive pattern. For example, the first sub-connection part SCP1 of the first connection part CP1 may include the first conductive pattern CMP1 and the second conductive pattern CMP2 disposed on the first conductive pattern CMP1.

In an embodiment, the first conductive pattern CMP1 may be disposed in the same layer as the first and second lower metal layers BML1 and BML2, and the second conductive pattern CMP2 may be disposed in the same layer as the first, second, third, and fourth electrodes E1, E2, E3, and E4. For example, the first conductive pattern CMP1 may include the same material as the first and second lower metal layers BML1 and BML2 and may be formed through the same process as the first and second lower metal layers BML1 and BML2. The second conductive pattern CMP2 may include the same material as the first, second, third, and fourth electrodes E1, E2, E3, and E4, and may be formed through the same process as the first, second, third, and fourth electrodes E1, E2, E3, and E4.

In an embodiment, the second conductive pattern CMP2 may be connected to the first conductive pattern CMP1 through the contact hole CNT_C penetrating the buffer layer BUR, the first insulating layer IL1, the second insulating layer IL2, the third insulating layer IL3, and the fifth insulating layer IL5. The first connection line CL1 may extend from the first conductive pattern CMP1, and the first-first gate signal line GL11 may extend from the second conductive pattern CMP2.

Referring to FIG. 13, the first sub-connection part SCP1 of the first connection part CP1 may include at least one conductive pattern. For example, the first sub-connection part SCP1 of the first connection part CP1 may include a first-first conductive pattern CMP11, a first-second conductive pattern CMP12 disposed on the first-first conductive pattern CMP11, and a second conductive pattern CMP2 disposed on the first-second conductive pattern CMP12.

In an embodiment, the first-first conductive pattern CMP11 may be disposed in the same layer as the first and second lower metal layers BML1 and BML2, the first-second conductive pattern CMP12 may be disposed in the same layer as the driver gate electrode GE_G, and the second conductive pattern CMP2 may be disposed in the same layer as the first, second, third, and fourth electrodes E1, E2, E3, and E4. For example, the first-first conductive pattern CMP11 may include the same material as the first and second lower metal layers BML1 and BML2 and may be formed through the same process as the first and second lower metal layers BML1 and BML2. The first-second conductive pattern CMP12 may include the same material as the driver gate electrode GE_G and may be formed through the same process as the driver gate electrode GE_G. The second conductive pattern CMP2 may include the same material as the first to fourth electrodes E1, E2, E3, and E4, and may be formed through the same process as the first to fourth electrodes E1, E2, E3, and E4.

In an embodiment, the second conductive pattern CMP2 may be connected to the first-first conductive pattern CMP11 through a first contact hole CNT_C1 penetrating the buffer layer BUR, the first insulating layer IL1, the second insulating layer IL2, the third insulating layer IL3, and the fifth insulating layer IL5. The second conductive pattern CMP2 may be connected to the first-second conductive pattern CMP12 through a second contact hole CNT_C2 penetrating the second insulating layer IL2, the third insulating layer IL3, and fifth insulating layer IL5.

The first-first connection line CL11 may extend from the first-first conductive pattern CMP11, the first-second connection line CL12 may extend from the first-second conductive pattern CMP12, and the first-first gate signal line GL11 may extend from the second conductive pattern CMP2. For example, one gate stage of the first gate driver GDV1 and one first sub-connection part SCP1 may be connected through two connection lines.

Referring to FIG. 14, the first sub-connection part SCP1 of the first connection part CP1 may include at least one conductive pattern. For example, the first sub-connection part SCP1 of the first connection part CP1 may include the first conductive pattern CMP1 and the second conductive pattern CMP2 disposed on the first conductive pattern CMP1.

In an embodiment, the first conductive pattern CMP1 may be disposed in the same layer as the driver gate electrode GE_G, and the second conductive pattern CMP2 may be disposed in the same layer as the second-second pixel gate electrode GE22_P. For example, the first conductive pattern CMP1 may include the same material as the driver gate electrode GE_G and may be formed through the same process as the driver gate electrode GE_G. The second conductive pattern CMP2 may include the same material as the second-second pixel gate electrode GE22_P and may be formed through the same process as the second-second pixel gate electrode GE22_P.

In an embodiment, the second conductive pattern CMP2 may be connected to the first conductive pattern CMP1 through the contact hole CNT_C penetrating the second insulating layer IL2, the third insulating layer IL3, and the fourth insulating layer IL4. The first connection line CL1 may extend from the first conductive pattern CMP1, and the first-first gate signal line GL11 may extend from the second conductive pattern CMP2.

Referring to FIG. 15, the first sub-connection part SCP1 of the first connection part CP1 may include at least one conductive pattern. For example, the first sub-connection part SCP1 of the first connection part CP1 may include the first conductive pattern CMP1 and the second conductive pattern CMP2 disposed on the first conductive pattern CMP1.

In an embodiment, the first conductive pattern CMP1 may be disposed in the same layer as the first and second lower metal layers BML1 and BML2, and the second conductive pattern CMP2 may be disposed in the same layer as the second-second pixel gate electrode GE22_P. For example, the first conductive pattern CMP1 may include the same material as the first and second lower metal layers BML1 and BML2 and may be formed through the same process as the first and second lower metal layers BML1 and BML2. The second conductive pattern CMP2 may include the same material as the second-second pixel gate electrode GE22_P and may be formed through the same process as the second-second pixel gate electrode GE22_P.

In an embodiment, the second conductive pattern CMP2 may be connected to the first conductive pattern CMP1 through the contact hole CNT_C penetrating the buffer layer BUR, the first insulating layer IL1, the second insulating layer IL2, the third insulating layer IL3, and the fourth insulating layer IL4. The first connection line CL1 may extend from the first conductive pattern CMP1 and the first-first gate signal line GL11 may extend from the second conductive pattern CMP2.

As a result, the first conductive pattern CMP1 may be disposed in the same layer as any one of the first and second lower metal layers BML1 and BML2 and the driver gate electrode GE_G, and the second conductive pattern CMP2 may be disposed in the same layer as any one of the third electrode E3, the fourth electrode E4, and the second-second pixel gate electrode GE22_P.

Referring again to FIGS. 12, 13, 14, and 15, in an embodiment, the area of the contact holes CNT_C, CNT_C1, and CNT_C2 may be larger than the areas of each of the third and fourth contact holes CNT3 and CNT4.

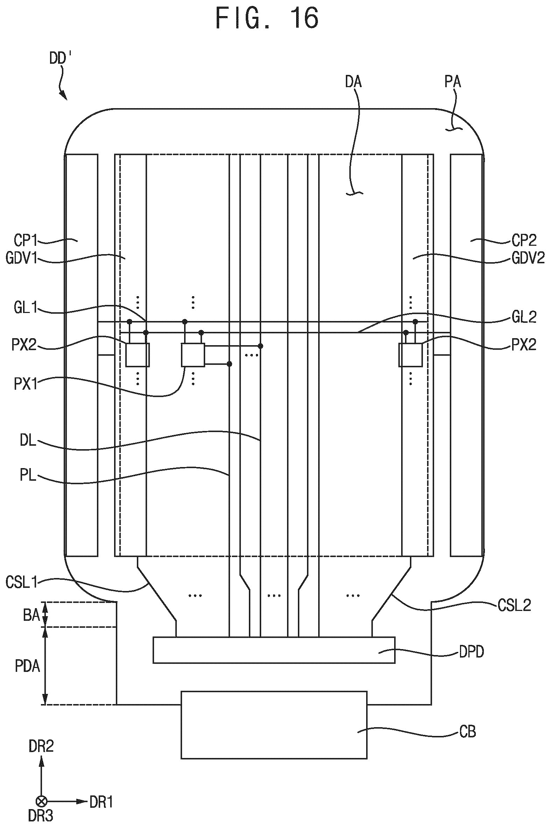

FIG. 16 is a schematic plan view showing a display device according to an embodiment. A display device DD' of FIG. 16 may be substantially the same as or similar to the display device DD described with reference to FIG. 1 except for the positions of the first and second gate drivers GDV1 and GDV2. Hereinafter, overlapping descriptions may be omitted.

In an embodiment, the first gate driver GDV1 and the second gate driver GDV2 may be disposed in the display area DA. For example, each of the first gate driver GDV1 and the second gate driver GDV2 may partially overlap the display area DA. For example, each of the first gate driver GDV1 and the second gate driver GDV2 may partially overlap the display area DA and partially overlap the peripheral area PA. In this case, each of the first gate driver GDV1 and the second gate driver GDV2 may at least partially overlap a pixel structure (for example, the second pixel structure PX2) in the plan view.

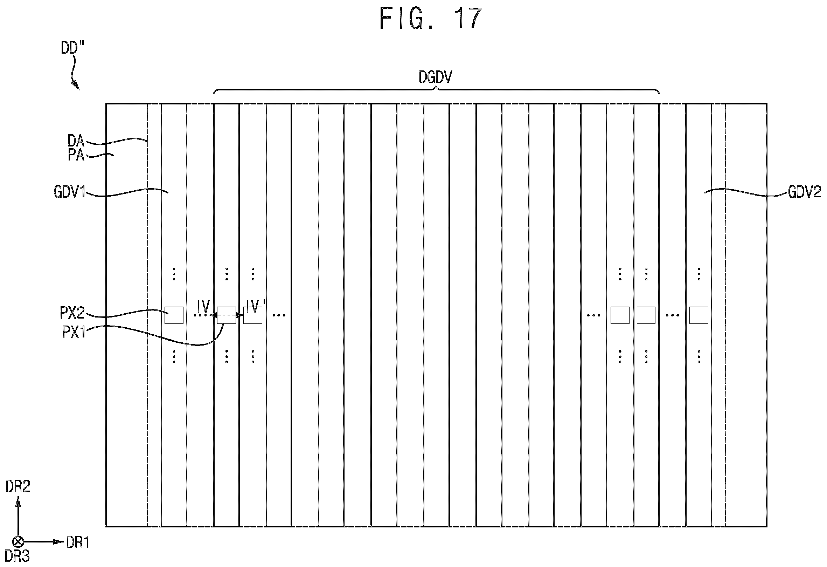

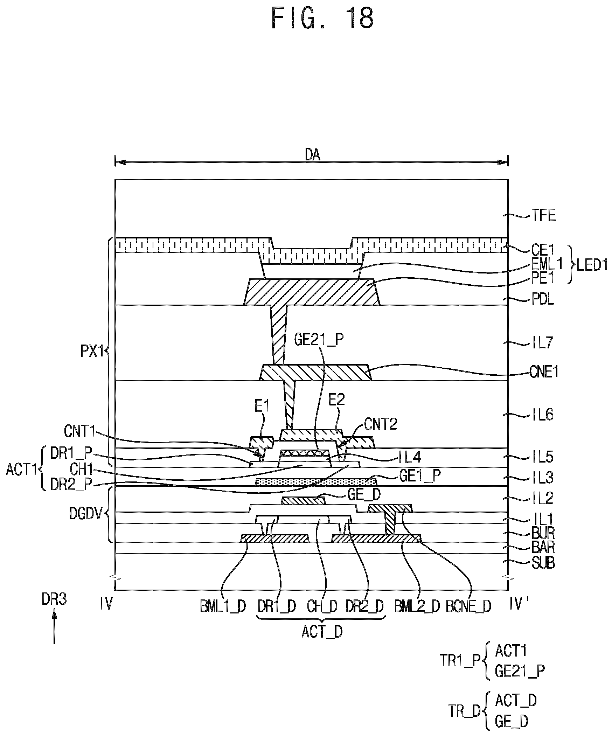

FIG. 17 is a schematic plan view showing a portion of a display device according to an embodiment. FIG. 18 is a schematic cross-sectional view taken along line IV-IV' of FIG. 17.

A display device DD" described with reference to FIGS. 17 and 18 may be substantially the same as or similar to the display device DD described with reference to FIGS. 1, 2, 3, and 4 except that the display device DD" may further include a dummy gate driver DGDV Hereinafter, overlapping descriptions may be omitted.

Referring to FIGS. 17 and 18, in an embodiment, the display device DD" may further include at least one dummy gate driver DGDV disposed in the display area DA and spaced apart from the first and second gate drivers GDV1 and GDV2. The dummy gate driver DGDV may not be electrically connected to the first and second pixel structures PX1 and PX2.

The dummy gate driver DGDV may be disposed under or below the first pixel structure PX1. For example, the first pixel structure PX1 may at least partially overlap the dummy gate driver DGDV in the plan view.

The dummy gate driver DGDV may include a dummy transistor TR_D, a first dummy lower metal layer BML1 _D, a second dummy lower metal layer BML2 _D, and a dummy connection pattern BCNE_D. The dummy transistor TR_D may include a dummy active layer ACT_D and a dummy gate electrode GE_D.

The dummy active layer ACT_D and the dummy gate electrode GE_D may include the same material as the driver active layer ACT _G and the driver gate electrode GE_G of FIG. 4 and may be disposed in the same layer as the driver active layer ACT_G and the driver gate electrode GE_G of FIG. 4, respectively. The first dummy lower metal layer BML1_D, the second dummy lower metal layer BML2 _D, and the dummy connection pattern BCNE_D may include the same material as the first lower metal layer BML1, the second lower metal layer BML2, and the connection pattern BCNE of FIG. 4 and may be disposed in the same layer as the first lower metal layer BML1, the second lower metal layer BML2, and the connection pattern BCNE of FIG. 4, respectively.

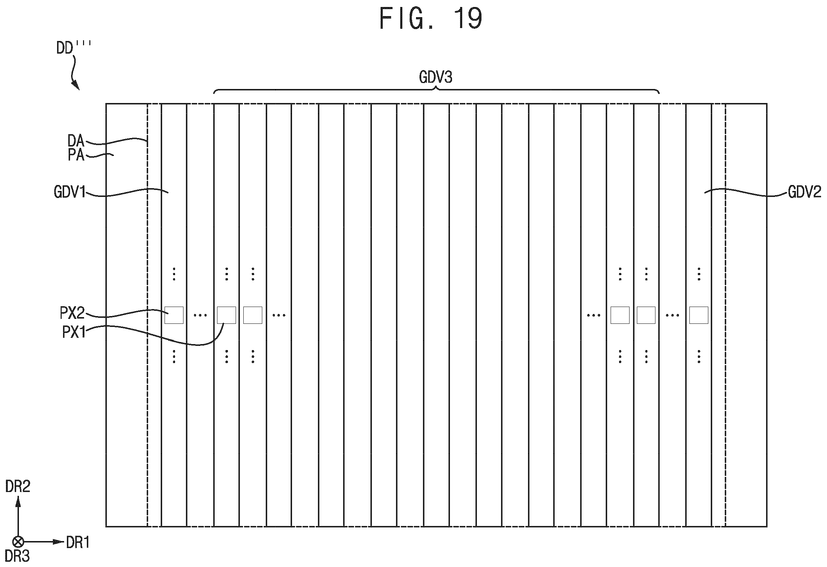

FIG. 19 is a schematic plan view showing a portion of a display device according to an embodiment.

A display device DD‴ described with reference to FIG. may be substantially the same as or similar to the display device DD described with reference to FIGS. 1, 2, 3, and 4 except that the display device DD‴ further may include an additional gate driver GDV3. Hereinafter, overlapping descriptions may be omitted.

Referring to FIG. 19, in an embodiment, the display device DD‴ may further include at least one additional gate driver GDV3 disposed in the display area DA and spaced apart from the first and second gate drivers GDV1 and GDV2. The additional gate driver GDV3 may generate a gate signal and be electrically connected to at least one of the first and second pixel structures PX1 and PX2. For example, like the first and second gate driver GDV1 and GDV2, the additional gate driver GDV3 may be connected to at least one of the first and second pixel structures PX1 and PX2 through a connection part disposed in the peripheral area PA.

The additional gate driver GDV3 may be disposed under or below the first pixel structure PX1. For example, the first pixel structure PX1 may at least partially overlap the additional gate driver GDV3 in the plan view.

The cross-sectional structure of the additional gate driver GDV3 may be substantially the same as or similar to the cross-sectional structure of the dummy gate driver DGDV of FIG. 18.

Referring again to FIGS. 1 to 9, in the display device according to embodiments, a gate driver (for example, the first gate driver GDV1 or the second gate driver GDV2 of FIG. 1) that generates the gate signal may be disposed in the display area DA, and a pixel structure (for example, the second pixel structure of FIGS. 1 and 2) that at least partially overlaps the gate driver in the plan view may be disposed in the display area DA on the gate driver. The gate driver may be connected to the pixel structure through a connection part (for example, the first connection part CP1 or the second connection part CP2 of FIG. 1) disposed in the peripheral area PA. Accordingly, the dead space of the display device may be reduced.

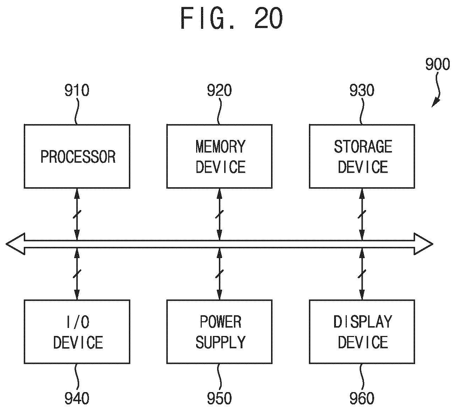

FIG. 20 is a schematic block diagram illustrating an electronic device according to an embodiment.

Referring to FIG. 20, in an embodiment, an electronic device 900 may include a processor 910, a memory device 920, a storage device 930, an input/output device 940, a power supply 950, and a display device 960. In this case, the display device 960 may correspond to the display device DD, DD', DD", or DD‴ described with reference to FIGS. 1 to 19. The electronic device 900 may further include several ports capable of communicating with a video card, a sound card, a memory card, a USB device, and the like.

In an embodiment, the electronic device 900 may be implemented as a television. In another embodiment, the electronic device 900 may be implemented as a smart phone. However, the electronic device 900 is not limited thereto, and for example, the electronic device 900 may be implemented as a mobile phone, a video phone, a smart pad, a smart watch, a tablet PC, a vehicle navigation device, a computer monitor, a laptop computer, a head mounted display (HMD), and the like.

The processor 910 may perform certain calculations or tasks. The processor 910 may control the display device 960. In an embodiment, the processor 910 may be a microprocessor, a central processing unit (CPU), an application processor (AP), and/or the like. The processor 910 may be connected to other components through an address bus, a control bus, a data bus, and the like. The processor 910 may also be connected to an expansion bus, such as a peripheral component interconnect (PCI) bus.

The memory device 920 may store data necessary for the operation of the electronic device 900. For example, the memory device 920 may include an erasable programmable read-only memory (EPROM) device, an electrically erasable programmable read-only memory (EEPROM) device, a flash memory device, a phase change random access memory (PRAM) device, a resistance random access memory (RRAM) device, a nano floating GEe memory (NFGM) device, a polymer random access memory (PoRAM) device, a magnetic random access memory (MRAM) device, a non-volatile memory device such as a ferroelectric random access memory (FRAM) device and/or a volatile memory device such as a dynamic random access memory (DRAM) device, a static random access memory (SRAM) device, and a mobile DRAM device, and the like.

The storage device 930 may include a solid state drive (SSD), a hard disk drive (HDD), a CD-ROM, and the like.

The input/output device 940 may include input means such as a keyboard, keypad, touch pad, touch screen, mouse, and the like and output means such as a speaker, a printer, and the like.

The power supply 950 may supply power necessary for the operation of the electronic device 900. The display device 960 may be connected to other components through buses or other communication links. In an embodiment, the display device 960 may be included in the input/output device 940.

The disclosure can be applied to various display devices. For example, the disclosure is applicable to various display devices such as display devices for vehicles, ships and aircraft, portable communication devices, display devices for exhibition or information transmission, medical display devices, and the like within the scope of the disclosure.

As discussed, embodiments can provide a display device comprising: a substrate including a display area and a peripheral area surrounding at least a portion of the display area; a gate driver disposed in the display area on the substrate, the gate driver including a driver transistor, and being arranged to generate a first gate signal; a plurality of first pixel members disposed on the gate driver, each of the plurality of first pixel members including a first pixel transistor, and each of the plurality of first pixel members at least partially overlapping the gate driver in a plan view; a connection part disposed in the peripheral area adjacent to the gate driver on the substrate, the connection part including a first conductive pattern and a second conductive pattern disposed on the first conductive pattern, the second conductive pattern being electrically connected to the first conductive pattern through a contact hole; a connection line extending from the first conductive pattern and electrically connected to the gate driver; and a gate signal line disposed on the connection line and extending from the second conductive pattern, the gate signal line being electrically connected to each of the plurality of first pixel members.

Embodiments can provide a display device comprising: a substrate including a display area and a peripheral area surrounding at least a portion of the display area; a gate driver disposed in the display area on the substrate, the gate driver being arranged to generate a first gate signal, and including a plurality of gate stages each including a driver transistor; a plurality of first pixel members disposed on the gate driver, each of the plurality of first pixel members including a first pixel transistor, and each of the plurality of first pixel members at least partially overlapping the plurality of gate stages in a plan view; a connection part disposed in the peripheral area adjacent to the gate driver on the substrate and including a plurality of sub-connection parts each including a first conductive pattern and a second conductive pattern disposed on the first conductive pattern, the second conductive pattern being electrically connected to the first conductive pattern through a contact hole; a connection line extending from the first conductive pattern of one of the sub-connection parts and electrically connected to the each of the plurality of gate stages; and a gate signal line disposed on the connection line and extending from the second conductive pattern of one of the sub-connection parts, the gate signal line being electrically connected to each of the plurality of first pixel members.

Embodiments can provide an electronic device comprising: a display device; and a processor which controls the display device, wherein the display device is according to any of the above mentioned embodiments.

The foregoing is illustrative of embodiments and is not to be construed as limiting thereof. Although embodiments have been described, those skilled in the art will readily appreciate that many modifications are possible in the embodiments without materially departing from the novel teachings and advantages of the disclosure. Accordingly, all such modifications are intended to be included within the scope of the disclosure and as defined in the claims. Therefore, it is to be understood that the foregoing is illustrative of various embodiments and is not to be construed as limited to the embodiments disclosed, and that modifications to the disclosed embodiments, as well as other embodiments, are intended to be included within the scope of the appended claims.

## Claims

1. A display device comprising:
a substrate including a display area and a peripheral area surrounding at least a portion of the display area;
a gate driver disposed in the display area on the substrate, the gate driver including a driver transistor, and being arranged to generate a first gate signal;
a plurality of first pixel members disposed on the gate driver, each of the plurality of first pixel members including a first pixel transistor, and each of the plurality of first pixel members at least partially overlapping the gate driver in a plan view;
a connection part disposed in the peripheral area adjacent to the gate driver on the substrate, the connection part including a first conductive pattern and a second conductive pattern disposed on the first conductive pattern, the second conductive pattern being electrically connected to the first conductive pattern through a contact hole;
a connection line extending from the first conductive pattern and electrically connected to the gate driver; and
a gate signal line disposed on the connection line and extending from the second conductive pattern, the gate signal line being electrically connected to each of the plurality of first pixel members.

2. The display device of claim 1, wherein the gate driver overlaps a left edge of the display area or a right edge of the display area.

3. The display device of claim 1 or 2, further comprising:
a shielding pattern disposed between the gate driver and the plurality of first pixel members, the shielding pattern at least partially overlapping the driver transistor in a plan view.

4. The display device of any one of claims 1 to 3, further comprising:
a plurality of second pixel members disposed in the display area on the gate driver, each of the plurality of second pixel members including a second pixel transistor, and each of the plurality of second pixel members not overlapping the gate driver in a plan view.

5. The display device of any one of claims 1 to 4, wherein the first pixel transistor includes
a first pixel active layer disposed on the gate driver; and
a pixel gate electrode disposed on the first pixel active layer and partially overlapping a channel region of the first pixel active layer in a plan view,
wherein each of the plurality of first pixel members further includes:
a first electrode disposed on the first pixel active layer and electrically connected to a first doped region of the first pixel active layer through a first contact hole; and
a second electrode disposed on the first pixel active layer and electrically connected to a second doped region of the first pixel active layer through a second contact hole;
optionally wherein a size of the contact hole is different from a size of each of the first contact hole and the second contact hole;
optionally wherein a size of the contact hole is larger than a size of each of the first contact hole and the second contact hole;
optionally wherein the first pixel active layer includes a metal oxide semiconductor.

6. The display device of claim 5, wherein the driver transistor includes:
a driver active layer disposed on the substrate; and
a driver gate electrode disposed on the driver active layer and overlapping a channel region of the driver active layer;
optionally wherein the driver active layer includes a silicon semiconductor.

7. The display device of claim 6, wherein the gate driver further includes:
a lower metal layer disposed between the substrate and the driver active layer, the lower metal layer being electrically connected to the driver active layer; and
a connection pattern and the driver gate electrode disposed on a same layer, the connection pattern being electrically connected to the lower metal layer.

8. The display device of claim 7, wherein
the first conductive pattern and the driver gate electrode are disposed in a same layer, and the second conductive pattern and the first electrode and the second electrode are disposed in a same layer; or
the first conductive pattern and the lower metal layer are disposed in a same layer, and the second conductive pattern and the first electrode and the second electrode are disposed in a same layer; or
wherein the first conductive pattern and the driver gate electrode are disposed in a same layer, and the second conductive pattern and the pixel gate electrode are disposed in a same layer; or
wherein the first conductive pattern and the lower metal layer are disposed in a same layer, and the second conductive pattern and the pixel gate electrode are disposed in a same layer.

9. The display device of claim 8 or 9, wherein
the first conductive pattern includes:
a first-first conductive pattern, the first-first conductive pattern and the lower metal layer disposed in a same layer, and
a first-second conductive pattern, the first-second conductive pattern and the driver gate electrode disposed in a same layer,
the connection line includes a first-first connection line extending from the first-first conductive pattern and a first-second connection line extending from the first-second conductive pattern, and
the second conductive pattern and the first electrode and the second electrode are disposed in a same layer.

10. The display device of any one of claims 1 to 9, further comprising:
at least one dummy gate driver disposed in the display area on the substrate, the at least one dummy gate driver including a dummy transistor and being spaced apart from the gate driver; and
a plurality of second pixel members disposed in the display area on the dummy gate driver, each of the plurality of second pixel members including a second pixel transistor.

11. The display device of any one of claims 1 to 10, further comprising:
at least one additional gate driver disposed in the display area on the substrate, the at least one additional gate driver being arranged to generate a second gate signal; and
a plurality of second pixel members disposed in the display area on the additional gate driver, each of the plurality of second pixel members including a second pixel transistor,
wherein the additional gate driver is electrically connected to at least one of the plurality of first pixel members and the plurality of second pixel members.

12. A display device comprising:
a substrate including a display area and a peripheral area surrounding at least a portion of the display area;
a gate driver disposed in the display area on the substrate, the gate driver being arranged to generate a first gate signal, and including a plurality of gate stages each including a driver transistor;
a plurality of first pixel members disposed on the gate driver, each of the plurality of first pixel members including a first pixel transistor, and each of the plurality of first pixel members at least partially overlapping the plurality of gate stages in a plan view;
a connection part disposed in the peripheral area adjacent to the gate driver on the substrate and including a plurality of sub-connection parts each including a first conductive pattern and a second conductive pattern disposed on the first conductive pattern, the second conductive pattern being electrically connected to the first conductive pattern through a contact hole;
a connection line extending from the first conductive pattern of one of the sub-connection parts and electrically connected to the each of the plurality of gate stages; and
a gate signal line disposed on the connection line and extending from the second conductive pattern of one of the sub-connection parts, the gate signal line being electrically connected to each of the plurality of first pixel members.

13. The display device of claim 12, further comprising:
a shielding pattern disposed between the gate driver and the plurality of first pixel members, the shielding pattern at least partially overlapping the driver transistor in a plan view; and/or
a plurality of second pixel members disposed in the display area on the gate driver, each of the plurality of second pixel members including a second pixel transistor, and each of the plurality of second pixel members not overlapping the gate driver in the plan view.

14. The display device of claim 12 or 13, wherein the first pixel transistor includes a first pixel active layer disposed on the gate driver; and
a pixel gate electrode disposed on the first pixel active layer and partially overlapping a channel region of the first pixel active layer in the plan view,
each of the plurality of first pixel members further includes:
a first electrode disposed on the first pixel active layer and electrically connected to a first doped region of the first pixel active layer through a first contact hole; and
a second electrode disposed on the first pixel active layer and electrically connected to a second doped region of the first pixel active layer through a second contact hole;
optionally wherein a size of the contact hole is larger than a size of each of the first contact hole and the second contact hole;
optionally wherein the driver transistor includes: a driver active layer disposed on the substrate; and a driver gate electrode disposed on the driver active layer and overlapping a channel region of the driver active layer; further optionally wherein the gate driver further includes: a lower metal layer disposed between the substrate and the driver active layer, the lower metal layer being electrically connected to the driver active layer; and a connection pattern and the driver gate electrode disposed on a same, the connection pattern being electrically connected to the lower metal layer; still further optionally wherein the first conductive pattern and one of the lower metal layer and the driver gate electrode are disposed in a same layer and the second conductive pattern and one of the first electrode or the pixel gate electrode are disposed in a same layer.

15. The display device of any one of claims 12 to 14, further comprising:
at least one dummy gate driver disposed in the display area on the substrate, the at least one dummy gate driver including a dummy transistor and being spaced apart from the gate driver; and a plurality of second pixel members disposed in the display area on the dummy gate driver and each of the plurality of second pixel members including a second pixel transistor; and/or
at least one additional gate driver disposed in the display area on the substrate, the at least one additional gate driver being arranged to generate a second gate signal; and a plurality of second pixel members disposed in the display area on the additional gate driver and each of the plurality of second pixel members including a second pixel transistor, wherein the additional gate driver is electrically connected to at least one of the plurality of first pixel members and the plurality of second pixel members.

16. An electronic device comprising:
a display device; and
a processor which controls the display device,
wherein the display device includes:
a substrate including a display area and a peripheral area surrounding at least a portion of the display area;
a gate driver disposed in the display area on the substrate, the gate driver including a driver transistor, and being arranged to generate a first gate signal;
a plurality of first pixel members disposed on the gate driver, each of the plurality of first pixel members including a first pixel transistor, and each of the plurality of first pixel members at least partially overlapping the gate driver in a plan view;
a connection part disposed in the peripheral area adjacent to the gate driver on the substrate, the connection part including a first conductive pattern and a second conductive pattern disposed on the first conductive pattern, the second conductive pattern being electrically connected to the first conductive pattern through a contact hole;
a connection line extending from the first conductive pattern and electrically connected to the gate driver; and
a gate signal line disposed on the connection line and extending from the second conductive pattern, the gate signal line being electrically connected to each of the plurality of first pixel members.
